# EUROPÄISCHE PATENTSCHRIFT

(11) **EP 2 218 097 B1**
(45) Veröffentlichungstag und Bekanntmachung des Hinweises auf die Patenterteilung: **24.02.2016**
(21) Anmeldenummer: 08850453.5
(22) Anmeldetag: 07.11.2008
(51) Int. Cl.: H01L 21/66, B23K 20/00, H01L 21/607

(54) **VERFAHREN UND VORRICHTUNG ZUM ULTRASCHALLBONDEN**
METHOD AND APPARATUS FOR ULTRASONIC BONDING
PROCÉDÉ ET DISPOSITIF DE SOUDAGE PAR ULTRASONS

(30) Priorität: 12.11.2007 DE 102007054626
(43) Veröffentlichungstag der Anmeldung: 18.08.2010
(60) Teilanmeldung: 11176310.8
(73) Patentinhaber: Hesse GmbH, 33100 Paderborn (DE)
(72) Erfinder: HESSE, Hans-Jürgen, 33106 Paderborn (DE); BRÖKELMANN, Michael, 33129 Delbrück (DE); HAGENKÖTTER, Sebastian, 33098 Paderborn (DE)
(74) Vertreter: Wickord, Wiro
(86) Internationale Anmeldenummer: PCT/EP2008/065101
(87) Internationale Veröffentlichungsnummer: WO 2009/062887

(56) Entgegenhaltungen:
- EP-A- 0 275 877
- WO-A-99/19107
- WO-A-02/070185
- WO-A-2006/032316
- FR-A- 2 302 172
- US-A- 5 046 654
- US-A- 5 431 321
- BROKELMANN M ET AL: "Bond process monitoring via self-sensing piezoelectric transducers" FREQUENCY CONTROL SYMPOSIUM AND EXPOSITION, 2004. PROCEEDINGS OF THE 2 004 IEEE INTERNATIONAL MONTREAL, CANADA 23-27 AUG. 2004, PISCATAWAY, NJ, USA,IEEE, 23. August 2004 (2004-08-23), Seiten 125-129, XP010784600 ISBN: 978-0-7803-8414-9

## Beschreibung

Die Erfindung betrifft ein Verfahren nach dem Oberbegriff des Patentanspruchs 1. Ferner betrifft die Erfindung eine Bondvorrichtung, nach dem Oberbegriff des Patentanspruchs 5.

Das Wedge-Wedge-Bonden ist eine allgemein anerkannte und zuverlässige Technik zur Kontaktierung von Chip und Substrat. Es wird sowohl in der Leistungselektronik als auch in der Mikroelektronik eingesetzt. Zur Überwachung der Qualität des Bondprozesses wird aus der laufenden Produktion ein bestimmter Prozentsatz der Produkte einem zerstörenden Test unterzogen und mit statistischen Verfahren auf die Qualität des gesamten Fertigungsloses geschlossen.

Der Wunsch einer weitergehenden Qualitätskontrolle insbesondere in sicherheitsrelevanten Bereichen hat dazu geführt, dass in den letzten Jahren mehrere Verfahren entwickelt wurden, die ergänzend zu dem oben angeführten zerstörenden Test eine Inline-Überwachung ermöglichen. Zu erwähnen sind im wesentlichen zwei Methoden, zum Einen die nicht zerstörende mechanische Überprüfung einer Bondverbindung, bei der geringe Kräfte auf die Verbindung wirken (Zug- oder Scherkräfte), um ihre Festigkeit zu überprüfen, zum Anderen eine auf der Messung von Signalen, die unmittelbar aus dem Ultraschallgenerator oder dem Lagegeber des Transducers gewonnen werden können, beruhende Methode.

Die zweite Methode verwendet als Messgrößen den in den Transducer fließenden Strom, die Spannung am Ausgang des Ultraschallgenerators oder die Verformung des Drahtes oder eine Kombination aus diesen Größen.

Als Stellgrößen für die Festlegung eines Prozessfensters dienen die Bondkraft, die Ultraschallleistung sowie die Bondzeit. Diese Verfahren werden beschrieben in den Patenten US 4,606,490, EP 0 368 533 B1, EP 0 540189 B1. Wesentliches Merkmal dieser Verfahren ist, dass die gemessenen Größen relativ zu einer durch den Benutzer vorgegebenen Kennlinie verlaufen. Ein Schwachpunkt dieser Methode besteht darin, dass auch schlechte Bondverbindungen derartige Verformungs- und Stromverläufe zeigen können. Damit ist die angegebene Regel allenfalls notwendig, auf keinen Fall aber hinreichend zur Bestimmung der Bondqualität, mithin ungeeignet, einen qualitativ minderwertigen Bond mit Sicherheit zu erkennen.

Ein Versuch, diesen Mangel auszugleichen, findet sich in den Patentschriften EP 1 023 139 B1 und EP 1 342 201. In den älteren Verfahren wurde lediglich eine Messgröße betrachtet und als Qualitätsmaß zugrunde gelegt. Inden neuen Verfahren wird versucht, eine Verknüpfung der vorgenannten Größen vorzunehmen und daraus Qualitätskriterien abzuleiten. Anstelle des Stromes wird hier die elektrische Admittanz des Transducers als eine von der Ultraschallleistung weitestgehend unabhängige Größe verwendet. Aus der Kombination von Admittanzverlauf und Drahtverformung und deren Korrelation wird versucht, eine zuverlässigere Aussage über die Verbindungsqualität zu erlangen.

Auch diese Verfahren führen nicht zum Ziel, da die verwendeten Messgrößen nicht hinreichend mit den in der Verbindungszone stattfindenden physikalischen Vorgängen korrelieren. So entspricht beispielsweise die elektrische Resonanz (Phasenwinkel zwischen Strom und Spannung = Null) nicht der mechanischen Resonanz (Phasenwinkel zwischen Geschwindigkeit der Werkzeugspitze und der Spannung =Null), so dass Systeme, die nur die elektrischen Größen verwenden, nicht in mechanischer Resonanz betrieben werden. Weder die Geschwindigkeit der Werkzeugspitze noch die Reibung zwischen den Verbindungspartnern, also die physikalischen Größen, die unmittelbar für die Verbindungsbildung von entscheidender Bedeutung sind, werden mit den vorerwähnten Verfahren erfasst.

Die Verwendung eines in der Membran montierten Sensors ist in EP 1789 226 A1 bzw. WO 2006/032316 A1 der Anmelderin beschrieben.

Aus der EP 0 275 877 A, die als nächstliegender Stand der Technik angesehen werden kann, ist ein Verfahren zur Überwachung von Bondparametern bekannt, wobei die Bondkraft über Dehnungsmessstreifen und die Ultraschall-Schwingungsamplitude mittels eines am Bondarm befestigten piezoelektrischen Sensors ermittelt wird. Die Bondkraft wird dabei indirekt über die vertikale Verbiegung des Bondarms bestimmt.

Ein Verfahren zur Überwachung des Bondprozesses ist auch aus dem Tagungsbeitrag "Bond Process Monitoring via Self-Sensing Piezoelectric Transducers" (Brökelmann at all, Frequency Control Symposium and Exposition, 2004, Proceedings of the 2004 IEEE International Ultrasonics, Ferroelectrics, and Frequency Control Joint 50th Anniversary Conference, Seiten 125 - 129, ISBN: 978-0-7803-8414-9) bekannt. Es wird hierbei insbesondere vorgeschlagen, den Spannungs- und Stromverlauf am elektrischen Anschluss des Transducers zu überwachen, um auf dieser Basis unmittelbar aus dem Strom und die Qualität zu schließen oder über einen elektromechanisches Ersatzmodell und die Schwingungsamplitude an der Wedgespitze auf die Qualität zu schließen.

Die beschriebenen, bisher bekannt gewordenen Verfahren sind also nicht geeignet, die für die Beurteilung der Verbindungsqualität wesentlichen Daten zu erfassen und entsprechend zu verarbeiten. Insoweit können diese Verfahren die Anforderungen der Qualitätsüberwachung in vollautomatischen Bondern nicht erfüllen.

Gemäß einem ersten Aspekt geht die Erfindung aus von einem Verfahren zur Qualitätskontrolle beim Ultraschall-Bonden, insbesondere beim Ultraschall-Drahtbonden, bei welchem eine Transducer-Bondwerkzeug-Einheit und ein Ultraschall-Generator verwendet werden und bei dem während des Bondens mittels eines oder mehrerer Sensoren Messsignale von einem oder mehreren, während des Bondens variablen Parametern zur Beurteilung der Bondqualität und/oder zur Beeinflussung des Bondens, insbesondere mittels Steuerung oder Regeln des Bondprozesses, erfasst werden.

Vor dem Hintergrund der eingangs zum Stand der Technik erläuterten Schwierigkeiten liegt der Erfindung insofern zunächst die Aufgabe zugrunde, verbesserte Möglichkeiten zur Qualitätskontrolle bereit zu stellen, insbesondere weitere, für die Verbindungsbildung wesentliche bzw. aussagekräftige physikalische Größen darin einzubeziehen.

Zur Lösung der Aufgabe weist das erfindungsgemäße Verfahren die Merkmale des Patentanspruchs 1 auf. Die erfindungsgemäße Vorrichtung umfasst die Merkmale des Patentanspruchs 5.

Es sind beispielsweise die Geschwindigkeit der Wedge-Spitze und die Reibung zwischen den Verbindungspartnern für die Verbindungsbildung wesentliche und insofern für die Beurteilung des Bondvorganges aussagekräftige physikalische Größen bzw. Parameter des Bondprozesses. Diese sollen daher aus einem Sensorsignal extrahiert und einer Bewertungseinheit zur Verfügung gestellt werden. Dieser Bewertungseinheit kann dann ein geeignetes Modell als Referenz zugrunde liegen, auf dessen Basis die Bewertung der Prozessdaten möglich ist.

Während des Bondens wird zumindest ein den Zeit- Geschwindigkeits-Verlauf der Spitze des Ultraschallwerkzeuges in deren Schwingungsrichtung, insbesondere qualitativ oder bezüglich des Phasenverlaufes, repräsentierendes Geschwindigkeits-Verlauf-Messsignal erfasst. Insofern stellt der Zeit-Geschwindigkeits-Verlauf der Werkzeug- bzw. Wedge- Spitze einen Parameter (Bondparameter) dar, der als Messgröße bzw. als variable Größe des Bondvorganges dessen Beobachtung erlaubt. Die davon erzeugten Messsignale können als Eingangsgrößen für eine nachfolgende Auswertung, insbesondere zur Beurteilung der Bondqualität, und/oder zur Steuerung und/oder Regelung des gerade aktuellen und/oder nachfolgender Bondvorgänge verwendet werden. Es besteht die Möglichkeit, dass ergänzend einzelne oder mehrere weitere Eingangssignale aus unterschiedlichen Quellen mit einbezogen werden. In Betracht kommen alle prozessrelevanten Größen, beispielsweise aus der Kinematik die Drahtverformung, aus dem Ultraschallsystem die Frequenz, die Phasendifferenz zwischen Strom und Spannung sowie der Ultraschallstrom und aus zusätzlichen Sensoren beispielsweise die mechanische Ultraschallschwingung und die Phase zwischen Wedgegeschwindigkeit und Ultraschallstrom. Die Erfassung der Parameter bzw. Messgrößen kann kontinuierlich oder quasi kontinuierlich bzw. bei einer geeigneten Taktrate aufgenommen werden. Die dabei für eine jeweilige Messgröße während der Herstellung einer Bondverbindung, d. h. während eines Bondvorganges, ermittelten Zahlenwerte können als Wertekolonne zu einem Vektor (Merkmalsvektor) zusammengefasst werden, der für die weitere Auswertung und Verwendung zur Verfügung steht. Die dabei in einem Zeitintervall aufgenommen und ggf. zu einem Vektor zusammengefassten Werte werden nachfolgend in ihrer zeitlichen Reihenfolge auch als Verläufe bezeichnet. Als zweckmäßig wird angesehen, wenn die Erfassung bzw. Auflösung des Zeit-Geschwindigkeits-Verlaufes der Werkzeugspitze in deren Schwingungsrichtung in so feinen zeitlichen Schritten erfolgt, dass dabei der im allgemeinen aus Sinus- und/oder Kosinus-Anteilen zusammengesetzte zeitliche Verlauf abgebildet wird. Eine insofern eindeutige Erfassung kann für diese und bei Bedarf für weitere Messgrößen in Echtzeit erfolgen, vorzugsweise unter Verwendung einer FPGA-basierten Elektronik, welche sich über eine zusätzliche Schnittstelle an einen DDS- Ultraschallgenerator anschließen lässt.

Auch besteht die Möglichkeit, aus einzelnen oder mehreren der vorgenannten, zu Messgrößen bzw. Bondparametern ermittelten Signalen weitere prozessrelevante Größen abzuleiten. Insbesondere besteht die Möglichkeit, unter Verwendung der von dem Geschwindigkeitsverlauf der Werkzeugspitze ermittelten Sensorsignale abgeleitete Größen zu gewinnen, welche der Reibung zwischen der Werkzeug- bzw. Wedge-Spitze und dem Draht, die Reibung zwischen Draht und Substrat, die Ankopplung vom Draht an das Substrat, die Werkzeug- bzw. Wedgespitzenauslenkung bzw. -geschwindigkeit zugeordnet sind bzw. dies repräsentieren, Die Erzeugung abgeleiteter Signale aus Messsignalen kann beispielsweise durch Bearbeitung, insbesondere Transformation, von einzelnen oder mehreren Messsignalen (beispielsweise auch Filterung) und/oder durch rechnerische Verknüpfung von mehreren (beispielsweise zwei, drei usw.) Messsignalen durchgeführt werden. Beispielsweise kommt als abgeleitete Größe auch die mechanische Admittanz als Quotient der beiden Messgrößen Werkzeuggeschwindigkeit und Generatorspannung in Betracht. Weitere Beispiele sind die elektrische Admittanz als Quotient aus Strom und Spannung des Generators sowie die elektrische Impedanz als Kehrwert der Admittanz.

Des Weiteren stellen auf Ähnlichkeitsfunktionen (Texturvergleiche) basierende Größen weitere mögliche Eingangsgrößen, insbesondere auch für die Berechnung eines Qualitätsindex, insbesondere gemäß weiteren Aspekten der Erfindung, dar. Jede dieser Eingangsgrößen stellt einen Vektor dar, dessen Länge von der Aufzeichnungsdauer, der Abtastrate und ggf. angewandten Vorverarbeitungsoperationen abhängig ist.

Das Geschwindigkeits-Verlauf-Messsignal wird mittels eines Piezosensors aufgenommen, der vorzugsweise in/an einer Lagerung des Ultraschall-Transducers angeordnet ist und mittels dem insbesondere eine Querdehnung senkrecht zu einer sich ausbreitenden anregenden Ultraschallwelle messtechnisch erfassbar ist. Zu diesem Zweck wird ein Piezosensor verwendet, wie dieser in der WO 2006/032316 A1 der Anmelderin beschrieben ist. Untersuchungen mit einem solchen Sensor haben überraschend ergeben, dass die zu Vergleichszwecken mit einem Laserinterferometer gemessene Geschwindigkeit der Werkzeug-bzw. Wedge-Spitze mit der Sensorspannung bzgl. der Phasenlage übereinstimmt. Ausgehend von dieser Erkenntnis wird vorgeschlagen, dass der dem Ultraschall-Transducer von dem Ultraschall-Generator zugeleitete Zeit-Generatorspannungs-Verlauf gemessen, dass dies beispielsweise mittels eines Phasen-Komparators die Phasendifferenz zwischen dem Zeit- Generatorspannungs-Verlauf und dem Geschwindigkeits-Verlauf Messsignal ermittelt wird und dass mittels des Ultraschallgenerators die Schwingungsfrequenz des Ultraschallwerkzeuges so eingestellt bzw. verändert wird, dass die genannte Phasendifferenz verringert, vorzugsweise bis im wesentlichen oder bis genau auf Null, verringert wird. Es gelingt dadurch, einen Zustand mechanischer Resonanz zu erzeugen, der bei der Herstellung von Bondverbindungen erhebliche Vorteile bietet. Dies einerseits, dass sich in diesem Zustand ein optimales Übertragungsverhalten der Piezoschwingung zum Schweißwerkzeug ergibt und des weiteren nur besonders geringe Verluste auftreten. Erfindungsgemäß besteht die Möglichkeit, den Zustand mechanischer Resonanz kontrolliert anzufahren. In der Vergangenheit war dies unter anderem deshalb nicht möglich, da an den Bondvorrichtungen keine Möglichkeit zur Messung des Zeit-Geschwindigkeits-Verlaufes vorhanden war und insofern auch eine entsprechende Verwendung unbekannt. Statt dessen wurde in der Vergangenheit, allerdings nur mit begrenztem Erfolg, versucht, das Übertragungsverhalten

und die Verluste durch die Einstellung von elektrischer Resonanz zu verbessern. Dabei wurde mittels eines Phasenkomparators die Phasendifferenz zwischen Transducerstrom und Transducerspannung ermittelt und mittels eines Phasenreglers unter Veränderung der Schwingungsfrequenz auf Null eingeregelt. Der Zustand elektrischer Resonanz stimmt jedoch in der Regel nicht mit dem gewünschten Zustand der mechanischen Resonanz überein, so dass deren Einstellung nicht kontrolliert möglich war. Es wurde nun gefunden, dass bei der Werkzeugschwingung der Geschwindigkeits-Verlauf dem Messsignal des Piezosensors bis in hohe spektrale Anteile hinein so ähnlich ist, dass die mechanische Resonanz mit hoher Genauigkeit einstellbar ist. Zur Regelung der Phasendifferenz auf den Wert Null kann beispielsweise ein (an sich bekannter) PLL, d. h. phase locked loop bzw. geschlossener Regelkreis verwendet werden.

Eine weitere zweckmäßige Weiterbildung des Verfahrens wird darin gesehen, dass während einzelner Bondvorgänge oder nach dem Bonden mittels des Geschwindigkeits-Verlauf-Messsignals Reibungswert-Zeitverläufe als Ist-Vorläufe bzw. Ist-Vektoren der Reibung ermittelt werden, welche den Verlauf der während der Dauer einzelner Bondvorgänge veränderlichen Reibungskräfte charakterisieren. Die Ermittlung der Reibungswert-Zeitverläufe anhand des Geschwindigkeits-Zeitverlaufes kann auf eine dem Fachmann an sich geläufige Art und Weise erfolgen. Dabei kann eine Folge von Reibungswerten ermittelt werden, von denen jeder Reibungswert einen bestimmten Zeitpunkt eines Bondvorganges zugeordnet ist und dabei seinerseits insbesondere aus einer größeren Anzahl von Messsignalen der Werkzeugspitze abgeleitet worden ist. Das erhaltene "Reibwertsignal" bzw. dessen zeitlicher Verlauf kann als Summensignal der beim Bondvorgang zwischen dem Bondwerkzeug, dem Bonddraht und dem z. B. Substrat (vgl. auch die obigen Ausführungen) aufgefasst werden. Auch die während bspw. eines Bondvorganges erhaltenen Reibungssignale können zur weiteren Verarbeitung bspw. als Vektor behandelt werden. Entsprechend können Vektoren für Geschwindigkeitswerte und für Reibungswerte und für daraus abgeleitete Werte, wie bspw. die Admittanz gebildet werden. Erfindungsgemäß bestehen verschiedene Möglichkeiten, diese Verläufe bedarfsgerecht zur Beeinflussung des nachfolgenden Bondens und/oder zur Beurteilung von Bondergebnissen (Bondqualität) zu verwenden. Es besteht die Möglichkeit, dass der bei einem jeweils aktuellen Prozesszustand des Bondvorganges ermittelte Reibungswert (in dem oben erläuterten Sinne als abgeleitete Größe) zur Steuerung und/oder Regelung des weiteren Bondvorganges und/oder nachfolgender Bondvorgänge, vorzugsweise im Wege einer Beeinflussung von Stellgrößen wie beispielsweise Bondkraft, Ultraschallleistung, Bondzeit und/oder Ultraschallfrequenz verwendet wird. Alternativ oder kombinativ besteht die Möglichkeit, dass aus dem Reibungswert-Zeitverlauf und einem vorgegebenen Soll-Reibungswert-Zeitverlauf oder einem zuvor in einer Lernphase, vorzugsweise gemäß oder analog nachfolgend erläuterten Merkmalen, ermittelten und abgespeicherten Soll-Reibungswert-Zeltverlauf mittels eines Rechners ein die Qualität eines Bondvorganges bzw. einer Bondverbindung kennzeichnender Qualitätswert ermittelt wird. Beispielsweise kann auch der Soll-Verlauf der abgeleiteten Reibung als Vektor dargestellt und in seinen Elementen schrittweise mit zeitlich zugeordneten Elementen des Ist-Vektors verglichen werden. Beispielsweise kann aus den jeweiligen Differenzen ein Abweichungs-Vektor gebildet werden. Bezüglich der Möglichkeit, Sollwertverläufe von Messgrößen und/oder abgeleiteten Größen in einer vorangehenden Lernphase zu erzeugen, wird auch in diesem Zusammenhang Bezug auf die nachfolgende Beschreibung genommen. Auch besteht die Möglichkeit, dass der genannte Qualitätswert zur Steuerung und/oder Regelung von nachfolgenden Bondvorgängen, vorzugsweise im Wege einer Beeinflussung von Stellgrößen wie Bondkraft, Ultraschallleistung, Bondzeit und/oder Ultraschallfrequenz, verwendet wird. Eine weitere bevorzugte Anwendung kann sein, dass der Qualitätswert zur Beeinflussung von Stellgrößen des Bondprozesses, wie insbesondere Bondkraft, Ultraschallleistung, Bondzeit und/ oder Ultraschallfrequenz im Wege einer Steuerung oder Regelung und/oder bei Erreichen kritischer Werte zur Ausgabe von Warnsignalen verwendet wird. Es hat sich herausgestellt, dass die während einzelner Bondvorgänge auftretenden Verläufe der Werkzeuggeschwindigkeit in Schwingungsrichtung und daraus abgeleitete Verläufe (insbesondere der abgeleiteten Reibung) je nach Bondbedingungen eine im Vergleich zu herkömmlichen Auswertungsparametern (insbesondere der Drahtverformung) zuverlässigere Aussage über die Qualität eines Bondvorganges ermöglichen können. Das erfindungsgemäße Verfahren ermöglicht daher im Vergleich zum Stand der Technik eine präzisere Überwachung der Bondqualität und bei Bedarf (bspw. bei Änderung der Bondbedingungen) eine verbesserte Beeinflussung von Stellgrößen zum Erhalt einer gleichbleibend guten Bondqualität. Insbesondere besteht die Möglichkeit, einen Soll-Ist-Vergleich der abgeleiteten Reibung in eine Steuerung und/oder Regelung von Bondprozessen zu integrieren, wobei ggf. auch noch zusätzliche Parameter mit berücksichtigt werden könnten.

Betreffend den zuvor erläuterten ersten Aspekt schließt die Erfindung auch eine Bondvorichtung, vorzugsweise einen Drahtbonder, mit ein zur Herstellung und zur Qualitätskontrolle von Ultraschallbondverbindungen, aufweisend eine Transducer-Bondwerkzeug-Einheit und einen Ultraschallgenerator sowie zumindest einen Sensor zur Gewinnung von Messsignalen von zumindest einem während des Bondens variablen Parameter, wobei die Bondvorrichtung zumindest einen Sensor aufweist, der zur Erzeugung eines den Zeit-Geschwindigkeits-Verlauf der Spitze des Ultraschallwerkzeuges in deren Schwingungsrichtung repräsentierenden Geschwindigkeitsverlauf-Messsignals geeignet ist. Weiterbildungen wird auch auf die Merkmale der Ansprüche 13 und 14 gemäß der am internationalen Anmeldetag eingereichten Fassung und zu möglichen Vorteilen und Wirkungen Bezug auf die gesamte Beschreibung und die Figuren genommen. Wie in den Ansprüchen 13 und 14 gemäß der am internationalen Anmeldetag eingereichten Fassung angegeben, Bondvorrichtung weist die Speichermittel auf, in denen zumindest ein vorgegebener Soll-Reibungswert-Zeitverlauf oder zumindest ein zuvor in einer Lernphase ermittelter Soll-Reibungswert-Zeitverlauf ab gespeichert ist, sowie Rechenmittel, die an die Berechnung eines die Qualität eines Bondvorganges bzw. einer Bondverbindung kennzeichnenden Qualitätswertes unter Verwendung des Soll-Reibungs-Verlaufs und des bei einem Bondvorgang ermittelten Reibungswert-Zeitverlaufs als Ist-Verlauf, insbesondere mittels Berechnung eines Abweichungs-Verlaufs aus Differenzen zwischen einander zeitlich entsprechenden Werten beider Verläufe, angepasst sind. Es besteht insofern auch die Möglichkeit, dass die Bondvorrichtung in deren Charakteristik durch den Abweichungs-Verlauf und/oder den Qualitätswert beeinflussbare Steuer- und/oder Regelmittel zur Steuerung und/oder Regelung des aktuellen und/ oder von nachfolgenden Bondvorgängen aufweist, welche insbesondere auf Stellgrößen des Bondprozesses, wie insbesondere Bondkraft, Ultraschallleistung, Bondzeit und Ultraschallfrequenz, Einfluss nehmen. Die Erfindung schließt in diesem Zusammenhang auch einen Ultraschallgenerator ein, der die Phase zwischen der Geschwindigkeit der Wedge-Spitze und der Ultraschallspannung regelt, so dass das System bei Phase Null in seiner mechanischen Resonanz arbeitet.

Auf der Grundlage der vorangehend beschriebenen Zusammenhänge und Merkmale befasst sich die Erfindung in ihrem ersten Aspekt somit auch mit der Erzeugung prozessintegrierter Qualitätsüberwachungsmodule, insbesondere unter Verwendung von Reibung und mechanischer Admittanz (Quotient aus Geschwindigkeit der Wedge-Spitze und der Spannung des Generators), vorzugsweise bei fest vorgegebenen Referenzdaten (Solldaten). Dabei besteht die Möglichkeit der Verarbeitung von externen Sensorwerten. Auch besteht die Möglichkeit, dass Transducer-Wedge-System in seiner mechanischen Resonanz oder wahlweise in elektrischer Resonanz zu betreiben. Abgeleitete Größen für die Reibung und die Wedgegeschwindigkeit können aus Messgrößen ermittelt werden.

Ausgehend von dem beschriebenen Stand der Technik liegt einer ersten Weiterbildung der Erfindung die Aufgabe zugrunde, das Verfahren vorteilhaft weiterzubilden, so dass insbesondere eine genauere und zuverlässigere Beurteilung der Bondqualität ermöglicht wird.

Dieses erfolgt beispielsweise in Verbindung mit den ggf. zusätzlichen Merkmalen, - dass während der Zeitdauer von Bondvorgängen mittels Sensoren Messsignale von einem oder mehreren Parametern, wie insbesondere Stromstärke und/oder Spannung am Ultraschallgenerator oder Transducer und/oder Drahtverformung und/oder Ultraschallfrequenz bzw. Resonanzfrequenz und/oder Werkzeuggeschwindigkeit, aufgenommen und jeweils als insbesondere zeitlicher Ist-Verlauf bereitgestellt, insbesondere in einem Speicher gehalten werden,
- dass insbesondere vorgesehen ist, dass aus Messsignalen von einem oder mehreren Parametern des Bondprozesses ein oder mehrere Ist-Verläufe von aus dem/den Parametern abgeleiteten Größen gebildet werden,
- dass ein oder mehrere Ist-Verläufe jeweils einer Rechenoperation, insbesondere einer Vergleichsoperation, mit einem dem jeweiligen Ist-Verlauf bezüglich seines Parameters bzw. seiner abgeleiteten Größe zugeordneten, in einem Speicher abgelegten Soll-Verlauf unterzogen werden, wobei zu den Ist-Verläufen jeweils ein Abweichungs-Verlauf, insbesondere durch Vergleich von einander zeitlich zugeordneten Einzelweiten von Ist- und Soll-Verläufen, ermittelt wird
- und dass mittels geeigneter Rechenmittel aus einem oder mehreren Abweichungs-Verläufen jeweils ein Einzel-Qualitätsindex Qi und/oder ein die Qualität eines einzelnen Bondvorganges bzw. einer einzelnen Bondverbindung zusammengefasst charakterisierender Qualitätsindex Q berechnet und insbesondere abgespeichert und/oder zur Steuerung oder Regelung von folgenden Bondprozessen verwendet wird.

Die Ermittlung von Einzel-Qualitätsindices Qi, die im Rahmen der Erfindung auch als Merkmals-Extraktion (vgl. auch die Figuren) bezeichnet wird, ermöglicht in besonders übersichtlicher und aussagekräftiger Weise die Überwachung der Bondqualität und sogar, wie auch nachfolgend erläutert, die weitere Verwendung zur Steuerung und/oder Regelung des Herstellungsverfahrens von Bondverbindungen (d.h. des sog. Bondens). Dabei ist im Rahmen der Erfindung eine Mehrgrößen-Betrachtung bzw. Überwachung bevorzugt.

Die Ist-Verläufe, Soll-Verläufe und Abweichungs-Verläufe können grundsätzlich bzw. allgemein, d. h. auch im Zusammenhang mit den anderen Aspekten der Erfindung wieder beispielsweise eindimensionale Vektoren bzw. Wertefolgen mit vorzugsweise in der zeitlichen Reihenfolge der zugrundeliegenden Messsignale sortierten Werten sein. Insofern kann auch begrifflich von Vektoren (Merkmalsvektoren) anstelle von Verläufen gesprochen werden, also von Ist-Vektoren, Soll-Vektoren, Abweichungs-Vektoren usw.. Sie können vereinfacht als Wertekolonnen verstanden werden, wobei die Anzahl ihrer Zahlenwerte unter anderem von der bei den Messungen verwendeten Taktrate und der Dauer der Bondvorgänge bzw. Messungen abhängt. Dabei ist bevorzugt, dass Ist-Vektoren und Soll-Vektoren die gleiche Dimension bzw. Länge aufweisen, so dass in besonders anschaulicher Weise jeweils Paare aus Werten beider Vektoren, die einander in der Schrittfolge bzw. im Messzeitpunkt (also zeitlich) zugeordnet sind, zur Erzeugung von Werten des Abweichungsvektors ausgewertet werden können.

Wie zuvor beschrieben, können Merkmalsverläufe bzw. Merkmalsvektore aus gemessenen und/oder abgeleiteten Größen generiert werden. Bei der Berechnung eines Einzel-Qualitätsindex Qi wird der zugrunde liegende Merkmalsvektor bzw. dessen Abweichungs-Vektor vorzugsweise eine skalare Größe umgewandelt. Bezeichnet man die Anzahl der bei der Qualitätsberechnung zugrundeliegenden Merkmals-Vektoren bzw. Verläufe mit n, handelt es sich dabei um eine Abbildung von n Merkmalsvektoren, welche gleiche oder unterschiedliche Dimensionen aufweisen können, auf einen Merkmals-Vektor (Ergebnis-Vektor) der Dimension n. Vorzugsweise kann da- bei jedes Element des Ergebnis-Vektors als skalare Größe dem mathematischen Betrag des jeweils zugrunde liegenden Merkmals-Vektors entsprechen.

Bevorzugt ist vorgesehen, dass bei der Berechnung des Qual itätsindex Q zumindest einzelne der Qualitätsindices Qi bzw. der Abweichungsverläufe, insbesondere gemäß zuvor in einem Speicher abgelegter Informationen, individuell und insbesondere voneinander unabhängig gewichtet werden. Die Genauigkeit der Qualitätsbeurteilung lässt sich insbesondere auch noch dadurch steigern, dass bei der Berechnung ein oder mehrere Abweichungs-Verläufe zeitlich bzw. in ihrem Verlauf (d.h. bezüglich der verschiedenen Elemente des Abweichungs-Vektors) veränderlich gewichtet werden. Bevorzugt kann das erfindungsgemäße Verfahren so ausgeführt werden, dass mittels geeigneter Rechenmittel aus einzelnen Abweichungsverläufen jeweils ein Einzel-Qualitätsindex Qi, insbesondere unter individueller zeitlicher bzw. verlaufsmäßiger Gewichtung, gemäß abgespeicherten Informationen ermittelt wird und dass der Qualitätsindex Q aus mehreren Einzelqualitätsindices Qi gemäß einem abgespeicherten Algorithmus berechnet wird.

Diesen Verfahrensschritten liegt die nun gefundene Erkenntnis zugrunde, dass verschiedenen Bondparametern (oder daraus abgeleiteten Größen) bzw. deren gemessenen Zeitverläufen bei der Beurteilung der Bondqualität untereinander und auch einzelnen Bondparametern (oder daraus abgeleiteten Größen) innerhalb verschiedener Zeitintervalle eines Bondvorganges eine unterschiedlich starke Bedeutung zukommen kann. Dies bedeutet, dass für eine genaue Qualitätsbewertung ein Modell, welches nur einzelne, als wesentlich angenommene Bondparameter berücksichtigt, diese aber dafür über die gesamte Bonddauer, oder ein Modell, welches prinzipiell alle messtechnisch erfassten Parameter ständig berücksichtigt, je nach Bedingungen des Bondprozesses und den hierauf einwirkenden Störeinflüssen nicht ausreichend sein kann. Das Verfahren ermöglicht es nun, gefundene Erkenntnisse darüber, welche Bondparameter in welchen Zeitraumen innerhalb der Bonddauer eine größere oder kleinere Bedeutung haben können, in ein automatisiertes Verfahren zur Qualitätskontrolle bzw. in eine zu dessen Ausführung geeignete Bondvorrichtung zu integrieren. Entsprechende Erkenntnisse und Zusammenhänge können in Versuchen ermittelt und dann bspw. in einer Datenbank, einem Expertensystem oder dergleichen archiviert werden. Sollen später unter entsprechenden Bondbedingungen, d. h. für das gleiche Referenzsystem, Bondverbindungen hergestellt werden, können die archivierten Informationen in einen Arbeitsspeicher geladen werden, so dass eine insofern maßgeschneiderte Qualitätsbeurteilung möglich ist. So kann es unter bestimmten Voraussetzungen beispielsweise vorteilhaft sein, dem zeitlichen Verlauf der Drahtverformung gegen Ende eines Bondvorganges eine größere Bedeutung beizumessen. Ebenso wäre beispielsweise denkbar, einem die veränderliche Reibung repräsentierenden Verlauf in einem frühen Zeitintervall des Bondabschnittes eine im Vergleich zu einem späteren Zeitabschnitt größere Gewichtung beizumessen. Natürlich besteht auch die Möglichkeit, bei Bedarf bestimmte Bondparameter mit über die Bonddauer gleicher Gewichtung zu versehen. Entscheidend ist die Möglichkeit, dass verschiedene Bondparameter individuell und insofern voneinander unabhängig gewichtet werden können. Analog besteht auch die Möglichkeit, die individuelle Gewichtung von Bondparametern im Rahmen einer in Echtzeit arbeitenden Steuerung oder Regelung des Bondprozesses zur Beeinflussung von Stellgrößen einzusetzen. Beispielsweise wäre denkbar, dass die Ultraschallleistung am Anfang eines Bondvorganges unter stärkerer Gewichtung eines ersten Bondparameters und gegen Ende des Bondvorganges unter stärkerer Gewichtung eines Soll-Ist-Vergleichs für einen anderen Bondparameter beeinflusst wird.

Das Verfahren schließt nach dem Vorangehenden auch die Möglichkeit mit ein, dass Abweichungsverläufe einzelner Bond-Parameter zufolge ihrer individuellen Gewichtung nur zu bestimmten Zeitintervallen innerhalb von Bondvorgängen wertemäßig berücksichtigt werden. Dies lässt sich beispielsweise dadurch erreichen, dass diesen Parametern in anderen Zeitabschnitten des Bondvorganges die Gewichtung Null zugeordnet wird. Während auch hier die Erfassung der grundsätzlich berücksichtigten Bondparameter laufend während der Bonddauer erfolgt, kann die Gewichtung einzelner Bondparameter bei der Qualitätsbeurteilung während verschiedener Zeitintervalle unterschiedlich sein. Neben der Vorgabe der verschiedenen Gewichtungen selbst kann auch die Möglichkeit gegeben sein, die Anfangs- und Endpunkte für die verschiedenen Parameter individuell vorzugeben. Alternativ oder kombinativ zu sprunghaften Veränderungen der Gewichtung von Parametern können auch Gewichtungsfunktionen vorgegeben werden, bei denen sich der Gewichtungsfaktor in kleinen Schritten bzw. quasi kontinuierlich ändert. Möglich wäre dies bspw. durch die Vorgabe von Gewichtungsvektoren.

Es besteht auch, wie schon angesprochen, die Möglichkeit, dass aus Messsignalen verschiedener Parameter insbesondere mittels geeigneter Rechenmittel abgeleitete Größen gebildet und aus deren jeweiligen Ist-Verläufen durch rechnerischen Vergleich mit zuvor abgespeicherten Soll-Verläufen dieser abgeleiteten Größen wiederum Abweichungs-Verläufe ermittelt werden und dass diese Abweichungsverläufe zur zeitlich individuell gewichteten Ermittlung eines Qualitätsindex verwendet werden. Der Begriff Vergleich ist hier wie im Vorangehenden im Sinne der vielfältigen Möglichkeiten der Datenverarbeitung bzw. Rechenoperationen weit zu verstehen. In einem einfachen Beispiel könnte der Vergleich in einer einfachen Subtraktion bzw. Differenzbildung von Soll-Ist-Wertepaaren bestehen, es wären aber auch andere Algorithmen vorstellbar. Betreffend die bspw. durch Vektoren vorgegebenen Soll-Verläufe besteht die Möglichkeit, dass diese bspw. in einem Speicher fest vorgegeben sind (bspw. aus einem Expertensystem stammen) oder zuvor in einer Lernphase, vorzugsweise gemäß oder analog zu nachfolgend beschriebenen Merkmalen, ermittelt wurden. Auch besteht die Möglichkeit, dass Messsignale, welche die Werkzeug-Geschwindigkeit des Ultraschallwerkzeuges in dessen Schwingungsrichtung repräsentieren, gemäß einem oder mehreren der Ansprüche 1 bis 14 gemäß deren am internationalen Anmeldetag eingereichten Fassung ermittelt werden, wozu auch auf die diesbezügliche vorangehende Beschreibung Bezug genommen wird. Zur Automatisierung des zuvor beschriebenen Verfahrens ist auch bevorzugt, dass zumindest einzelne oder mehrere seiner Schritte mittels Software rechnergestützt durchgeführt werden. Eine bevorzugte Weiterbildung wird auch in der Möglichkeit gesehen, die ermittelten Einzelqualitätsindices oder den gesamten Qualitätsindex zur Verfeinerung der Steuerung und/oder Regelung des weiteren Bondbetriebs einzusetzen. Bevorzugt ist, dass eine oder mehrere, insbesondere voneinander unabhängig gewichtete und/oder zeitlich gewichtete Abweichungs-Verläufe und/oder ein oder mehrere Qualitätsindices Qi und/oder der Qualitätsindex Q zur Steuerung oder Regelung eines gerade laufenden und/oder nachfolgender Bondvorgänge verwendet werden. Stellgrößen können auch hier vorzugsweise die Bondkraft, die Ultraschallleistung sowie die Bondzeit sein.

Die Erfindung schließt auch betreffend ihrer ersten Weiterbildung weiterhin auch die ggf. zusätzlichen Merkmal einer Bondvorrichtung, vorzugsweise eines Drahtbonders, zur Herstellung und zur Qualitätskontrolle von Ultraschallbondverbindungen ein, der gemäß Anspruch 24 gemäß der am internationalen Anmeldetag eingereichten Fassung zur Durchführung des vorangehend beschriebenen Verfahrens geeignet ausgebildet ist. Demgemäß schließt die Erfindung eine Bondvorrichtung, insbesondere Ultraschall-Drahtbondvorrichtung, ein zur Herstellung und zur Qualitätskontrolle von Ultraschall-Bondverbindungen , aufweisend einen Ultraschallgenerator, einen Transducer und Bondwerkzeug, insbesondere ein Wedge, sowie einen oder mehrere Sensoren zur Erfassung von Messsignalen, insbesondere in Echtzeit, von verschiedenen, während des Bondens variablen Parametern, wie insbesondere Stromstärke und/oder Spannung am Ultraschallgenerator oder Transducer und/oder Drahtverformung und/oder Ultraschallfrequenz bzw. Resonanzfrequenz und/oder Werkzeuggeschwindigkeit in dessen Schwingungsrichtung, wobei vorgesehen ist, dass die Bondvorrichtung zur Durchführung des Verfahrens gemäß einem oder mehreren der Ansprüche 15 bis 23 gemäß der am internationalen Anmeldetag eingereichten Fassung geeignet ausgebildet ist. Auch bezüglich dieser Ansprüche wird auch wieder Bezug auf die vorangehende Beschreibung genommen. Zu möglichen bevorzugten Weiterbildungen der Bondvorrichtung wird auch Bezug auf die Merkmale der Ansprüche 25 bis 31 gemäß der am internationalen Anmeldetag eingereichten Fassung und zu möglichen Wirkungen und Vorteilen Bezug auf die gesamte Beschreibung genommen. Wie in den genannten Ansprüchen 25 bis 31 angegeben, besteht die Möglichkeit, - dass die Bondvorrichtung eine Signalverarbeitungseinheit aufweist, die Parameter-Sensordaten aufbereitet und insbesondere abgeleitete Größen, wie Admittanz, Impedanz, Geschwindigkeit oder Reibung, aus den Parametern ermittelt,
- dass die Bondvorrichtung Mittel, welche insbesondere Bestandteil der Signalverarbeitungseinheit sind, aufweist zur Erzeugung und Bereitstellung von Ist-Verläufen einzelner Parameter und/oder daraus abgeleiteter Größen, wobei die Ist-Verläufe Messwerten aus einem oder mehreren Bondvorgängen zugeordnet sind,
- dass die Bondvorrichtung einen Speicher aufweist, in welchem Soll-Verläufe zu Parametern und/oder abgeleiteten Größen abgespeichert sind,
- dass die Bondvorrichtung eine Bewertungseinheit aufweist, welche mit dem Speicher sowie mit den Sensoren und/oder der Signalverarbeitungseinheit in Verbindung steht und welche für einen oder mehrere ausgewählte Parameter und/oder abgeleitete Größen gesondert aus Ist-Verläufen und aus Soll-Verläufen gleicher Parameter bzw. abgeleiteter Größen Abweichungs-Verläufe und daraus Einzel-Qualitätsindices Qi ermittelt,
- und dass die Bondvorrichtung insbesondere eine Berechnungseinheit aufweist, welche mit der Bewertungseinheit verbunden ist und welche aus einzelnen oder mehreren Einzel-Qualitätsindices Qi einen Qualitätsindex Q berechnet.

Auch besteht die Möglichkeit, dass die Berechnungseinheit mit einem Speicher, insbesondere mit dem besagten Speicher, in Verbindung steht und Einzel-Qualitätsindices Qi und/oder den Qualitätsindex Q an den Speicher sendet. Es besteht auch die Möglichkeit, dass die Bewertungseinheit Mittel aufweist zur verlaufsmäßigen Gewichtung der Abweichungs-Verläufe bei der Berechnung der Einzel-Qualitätsindices Qi. Auch kann vorgesehen sein, dass die Berechnungseinheit Mittel aufweist zur individuellen bzw. voneinander unabhängigen Gewichtung der Einzel-Qualitätsindices Qi bei der Berechnung des Qualitätsindex Q. Die Bondvorrichtung kann Merkmale gemäß einem oder mehreren der Ansprüche 9 bis 14 gemäß der am internationalen Anmeldetag eingereichten Fassung aufweisen, wozu auch auf die diesbezügliche vorangehende Beschreibung Bezug genommen wird. Es besteht auch die Möglichkeit, dass die Bondvorrichtung eine Steuerungseinrichtung oder eine Regelungseinrichtung zur Steuerung bzw. Regelung des Bondprozesses aufweist, dass die Bewertungseinheit und/oder die Berechnungseinheit mit der Steuerungs- bzw. der Regelungseinrichtung der Bondvorrichtung zur Übertragung von Daten, insbesondere von unabhängig voneinander und/oder zeitlich gewichteten Abweichungsverläufen und/oder von Einzel-Qualitätsindices Qi und/oder dem Qualitätsindex Q, verbunden ist, und dass die Steuerungs- bzw. die Regelungseinheit die übertragenen Daten zur Steuerung bzw. Regelung des Bondprozesses, vorzugsweise zur Beeinflussung der Bondkraft und/oder der Ultraschallleistung und/oder der Bondzeit als Stellgrößen, verwendet. Bezüglich der genannten Ansprüche besteht auch die Möglichkeit, dass die Bondvorrichtung zumindest einen Rechner, insbesondere einen PC, aufweist, welcher mit der Signalverarbeitungseinheit und/oder der Bewertungseinheit und/oder der Berechnungseinheit und/oder dem besagten Speicher zur Ausführung eines Bondverfahrens gemäß einem oder mehreren der Verfahrensansprüche gemäß der am internationalen Anmeldetag eingereichten Fassung verbunden ist oder einzelne oder mehrere dieser Komponenten beinhaltet. Die Messgrößen bzw. Parameter, wie Strom, Drahtverformung, Resonanzfrequenz, Wedgegeschwindigkeit, Phasendifferenzen aus Ultraschallspannung und -strom bzw. Wedgegeschwindigkeit und Spannung, sowie die aus den Sensorsignalen abgeleiteten Größen, bspw. Admittanz bzw. Impedanz und Reibung, werden mit einem vorgegebenen oder gelernten zeitlichen Verlauf (Sollverlauf) verglichen. Aus der Abweichung der einzelnen Messgrößen von der zugehörigen Sollkurve bzw. Soll-Verlauf wird eine gewichtete Eingangsgröße für die nachfolgende Berechnung des Qualitätsindex bestimmt. Die Gewichtung der einzelnen Werte und der Zeitraum, in dem diese Werte betrachtet werden, sind einstellbar.

Messungen mit herkömmlichen Systemen haben insbesondere bei Verwendung dickerer Drähte gezeigt, dass die erfassten physikalischen Größen in Abhängigkeit der Bondoberflächen, der Substratmaterialien, der Steifigkeit des Aufbaus, der Eigenmodi des Gesamtsystems, der verwendeten Wedges und Drähte etc. sehr stark variieren. Die stark applikationsabhängigen Schwankungen der Prozessgrößen lassen die Verwendung von Kennlinien als applikationsübergreifend einsetzbare Referenzdaten bei Dickdrahtbondern nicht zu.

Einer zweiten Weiterbildung liegt vor diesem Hintergrund die zusätzliche Aufgabe zugrunde, ein Verfahren und eine Vorrichtung bereitzustellen, die zu verschiedensten Anwendungen - trotz unterschiedlicher Eingangsvoraussetzungen -passende Referenzdaten (Solldaten) für die Beurteilung der betrachteten Eingangsdaten erzeugen bzw. dabei im übertragenen Sinne lernen können.

Dieses erfolgt zunächst und im wesentlichen in Verbindung mit den ggf. zusätzlichen Merkmalen,
- dass für zumindest ein bestimmtes Bond Referenzsystem eine Lernphase durchgeführt wird unter Vorgabe von bestimmten, insbesondere dem Bond-Referenzsystem in einer Datenbank zugeordneten, Einstellungen der Bondvorrichtung, wobei die Lernphase ein bestimmtes Kollektiv, d.h. eine bestimmte Anzahl, von Lern-Bondvorgängen umfasst,
- dass während der Zeitdauer von Lern-Bondvorgängen mittels Sensoren jeweils bzw. separat Messsignale von einem oder zeitparallel von mehreren Parametern des Bondprozesses, wie insbesondere Stromstärke und/oder Spannung am Ultraschallgenerator und/oder Drahtverformung und/oder Ultraschallfrequenz bzw. Resonanzfrequenz und/oder Werkzeuggeschwindigkeit in Schwingungsrichtung, aufgenommen und jeweils als insbesondere zeitliche Lern-Verläufein einem Speicher gehalten werden,
- dass für zumindest einen Parameter für jeweils konstante bzw. gleiche, in den Lern-Verläufen unterschiedene bzw. berücksichtigte Zeitpunkte oder Messschritte aus dem Kollektiv der Lern-Bondvorgänge die Verteilung der Wahrscheinlichkeitsdichte oder der relativen Wahrscheinlichkeit der Messsignal-Werte ermittelt wird, insbesondere unter Verwendung eines Statistikmodells,
- und dass für die jeweiligen Verteilungen jeweils der Maximalwert bestimmt wird, dass aus den Maximalwerten der verschiedenen Verteilungen eine Erwartungs-Kennlinie gebildet wird und dass die Erwartungs-Kennlinie als gelernter Soll-Verlauf des betreffenden Parameters abgespeichert wird.

Die Erfassung von Messsignalen mittels der Sensoren kann kontinuierlich, quasi kontinuierlich oder ggf. auch mit einer gewünschten geringeren Taktrate durchgeführt werden. Der gewählte Begriff Lernphase soll veranschaulichen, dass während dieser Phase als Referenzverläufe dienende Soll-Verläufe (Soll-Vektoren) mittels des Bondverfahrens bzw. der Bondvorrichtung automatisiert generiert werden. Insofern könnte man anstelle von Lernphase auch von einer Generierungsphase für Referenz-Verläufe bzw. Soll-Verläufe sprechen.

Unter der Annahme, dass für die unterschiedlichen Ausgangsvoraussetzungen stabile Prozesse existieren, deren Prozessparameter die Herstellung von Bondverbindungen mit hinreichend hoher Qualität gewährleisten, kann für jede direkt gemessene und für jede abgeleitete Größe die zu ihr gehörende Statistik gelernt werden. Diese Lernphase dient der Erzeugung von Referenzdaten, die im späteren Automatikbetrieb als Grundlage zur Berechnung der Qualitätsindices dienen. Es wird also keine Kennlinie für die unterschiedlichen Prozesse fest einprogrammiert, sondern die Kennlinien werden unter der oben erwähnten Prämisse vom System selbst erzeugt.

Als Eingangsgrößen können dieselben Größen wie bisher beschrieben verwendet werden. Anhand der gelernten Statistik kann man Abweichungen quantitativ bewerten und für eine Qualitätsberechnung nutzen.

Eine zweckmäßige Verfahrensweise wird darin gesehen, dass für unterschiedliche Bond-Referenzsysteme, d. h. für Systeme, die sich bzgl. der Bondbedingungen unterscheiden, jeweils in gesonderten Lernphasen individuelle Soll-Verläufe erzeugt werden. Bei einem ersten Referenzsystem könnte es sich bspw. um ein System mit einem Keramiksubstrat handeln, bei einem zweiten unterschiedlichen Referenzsystem bspw. um einen Stecker, bei einem dritten Referenzsystem bspw. um einen Chip usw.. Die Unterscheidung der dabei unterschiedlichen Bondbedingungen, die zu unterschiedlichen Soll-Verläufen führen können, ist besonders beim sog. Dickdraht-Bonden von Bedeutung, da hier größere Abweichungen als beim Dünndraht-Bonden auftreten können. Insofern wird auch als zweckmäßig angesehen, wenn für ein bspw. bestimmtes Keramiksubstrat in Kombination mit unterschiedlichen Drahtstärken wiederum verschiedene Referenzsysteme gebildet bzw. dazu individuelle Soll-Vektoren angelegt werden. Praktisch kann zur Erzeugung der Soll-Verläufe für ein bestimmtes Referenzsystem so vorgegangen werden, dass während eines ersten Bondvorganges alle für eine Qualitätsbeurteilung im späteren Automatikbetrieb interessierenden Messgrößen parallel aufgenommen und in getrennten Vektoren abgelegt werden, wobei auch Vektoren für aus den Messgrößen abgeleitete Größen gebildet werden können. Dieser Schritt kann dann für einen zweiten und weitere Bondvorgänge wiederholt werden, wobei ein Bondkollektiv bspw. einhundert Bondvorgänge (oder auch eine abweichende Anzahl) umfassen kann. Werden die Messgrößen-Verläufe bspw. mit einer Abtastrate von 50 kHz auf- genommen, resultiert bei einer exemplarischen Dauer eines Bondvorganges von 10 m/sec eine Anzahl von fünfhundert Messwerten für jede Messgröße bzw. Messgrößen-Verlauf. Während der Lernphase sollten solche Einstellungen der Prozessparameter der Bondvorrichtung (bspw. Bondkraft, Ultraschallleistung und Bondzeit) gewählt werden, bei denen der Bondprozess für das spezielle Referenzsystem erwartungsgemäß so gut funktioniert, dass ein überwiegender, insbesondere ein statistisch signifikanter Anteil der erzeugten Bondverbindungen eine gute Bondqualität besitzt und allenfalls ein geringerer, insbesondere ein statistisch weniger signifikanter Anteil der Bondverbindungen eine ungeeignete Qualität aufweist. Solche Einstellungen können entweder von geschultem Personal nach Erfahrungswerten vorgewählt werden oder bspw. einer Datenbank, einem Expertensystem oder dergleichen entnommen werden. Während der Lernphase werden die Werte für alle in die Soll-Kurven bzw. Soll-Verläufe einfließenden Meßgrößen zueinander zeitlich parallel aufgenommen. Dabei besteht in vielfältiger Weise die Möglichkeit, die Messsignale mittels Signalverarbeitungskomponenten (bspw. Recheneinheiten, analogen Übertragungsgliedern usw.) aufzubereiten.

Die gelernten Soll-Verläufe können später bei einem Verfahren zur Herstellung von Bondverbindungen (Produktions- bzw. Automatikbetrieb) zur Qualitätskontrolle der Ultraschallverbindungen verwendet werden. Dazu besteht die Möglichkeit, dass für die Herstellung von Bondverbindungen für ein bestimmtes Bond-Referenzsystern die dazu während einer früheren Lernphase erstellten Soll-Verläufe,beispielsweise aus einer Datenbank, bereitgestellt, beispielsweise in einen Arbeitsspeicher eingelesen werden, dass während der Zeitdauer von Bondvorgängen mittels geeigneter Sensoren jeweils Messsignale von einem oder mehreren Parametern aufgenommen und jeweils als zeitli- che Ist-Verläufe in einem Speicher gehalten werden und dass für zumindest einen Parameter aus dem Ist-Verlauf und dem in der Lernphase gelernten Soll-Verlauf Abweichungs-Verläufe als sog. Fehlervektoren ermittelt werden. Dies kann in schon beschriebener Weise bspw. durch rechnerischen Vergleich voneinander zeitlich zugeordneten Werten aus den Soll- und Ist-Vektoren er-folgen. Es besteht die Möglichkeit, dass der Abweichungs-Verlauf zur Steuerung oder Regelung des aktuellen und/oder nachfolgender Bondherstellungsvorgänge (Bondvorgänge) verwendet wird. Als zweckmäßige Weiterbildung wird angesehen, dass zu dem Statistikmodell ein Konfidenzintervall von bestimmter Größe um das Verteilungsmaximum vorgegeben wird, dass in den jeweiligen Verteilungen die Werte an dem unteren und/oder oberen Intervallrand ermittelt werden, dass aus den Werten des unteren Intervallrandes eine untere Rand-Kennlinie und/oder aus den Werten des oberen Intervallrandes eine obere Rand-Kennlinie gebildet werden und dass bei der Herstellung von Bondverbindungen ermittelte Ist-Verläufe rechnerisch mit der unteren und/ oder der oberen Rand-Kennlinie verglichen werden. Insbesondere besteht die Möglichkeit, dass bei einer Überschreitung der oberen Rand- Kennlinie und/ oder bei einer Unterschreitung der unteren Rand-Kennlinie ein Fehlersignal erzeugt wird und/oder in einer Datenbank abgespeichert wird und/oder dem gebondeten Produkt mittels einer Kennzeichnung zu dessen späterer Aussonderung oder Reparatur zugeordnet wird und/oder wobei von einem Prozesssteuer oder -regelsystem eine Benutzereingabe abgefordert wird. Derartige Alternativen können auch vorgesehen sein, wenn bspw. der für einen jeweiligen Bondvorgang berechnete Qualitätsindex Q (oder einzelne oder mehrere Einzel-Qualitätsindices Qi) bestimmte Grenzwerte über- oder unterschreiten. Es versteht sich, dass die besagten Abweichungs-Verläufe je nach Bedarf für mehrere Parameter ermittelt werden können. Auch besteht die Möglichkeit, dass in der Lernphase aus den Messsignalen von Parametern bzw. aus Erwartungs-Verläufen auch Soll-Verläufe für abgeleitete Parameter ermittelt werden, dass während der anschließenden Herstellung von Bondverbindungen aus den Messsignalen bzw. aus Ist-Verläufen von Messsignalen auch Ist-Verläufe für die besagten abgeleiteten Parameter ermittelt werden und dass aus einander für abgeleitete Parameter zugeordneten Soll-Verläufen und Ist-Verläufen auch den abgeleiteten Parametern zugeordneten Abweichungs-Verläufe ermittelt werden. Die besagten Abweichungs-Verläufe von Messgrößen und/oder abgeleiteten Größen können ihrerseits zur Bestimmung von Einzelqualitätsindices und/oder eines gesamten Qualitätsindex verwendet werden, vorzugsweise gemäß einem oder mehreren oder mit Bezug auf die Figuren beschriebenen Merkmalen. Es besteht auch die Möglichkeit, dass ein oder mehrere Soll-Verläufe, die gemäß einem oder mehreren der Ansprüche 32 bis 39 gemäß deren am internationalen Anmeldetag eingereichten Fassung ermittelt wurden, in einem Verfahren gemäß einem oder mehreren der Ansprüche 15 bis 23 gemäß deren am internationalen Anmeldetag eingereichten Fassung verwendet werden. Betreffend diese Ansprüche wird hier auch Bezug auf die vorangehende Beschreibung genommen. Auch bei dem zuvor beschriebenen Verfahren besteht die Möglichkeit, dass zumindest einzelne oder mehrere Verfahrensschritte mittels Software rechnergestützt automatisch durchgeführt werden.

Die Erfindung schließt auch betreffend ihrer zweiten Weiterbildung weiterhin auch die ggf. zusätzlichen Merkmale einer Bondvorrichtung, vorzugsweise einer Ultraschall-Drahtbondvorrichtung, zur Herstellung und/oder zur Qualitätskontrolle von Ultraschall-Bondverbindungen, gemäß Anspruch 42 gemäß der am internationalen Anmeldetag eingereichten Fassung mit ein, die zur Durchführung des erfindungsgemäßen Verfahrens gemäß einem oder mehreren der dazu vorangehend beschriebenen Merkmale geeignet bzw. daran angepasst ausgebildet ist. Demgemäß betrifft die Erfindung eine Bondvorrichtung, insbesondere Ultraschall-Drahtbondvorrichtung, zur Herstellung und zur Qualitätskontrolle von Ultraschall-Bondverbindungen, aufweisend einen Ultraschallgenerator, einen Transducer und Bondwerkzeug, insbesondere ein Wedge, sowie einen oder mehrere Sensoren zur Erfassung von Messsignalen, insbesondere in Echtzeit, von verschiedenen, während des Bondens variablen Parametern, wie insbesondere Stromstärke und/oder Spannung am Ultraschallgenerator oder Transducer und/oder Drahtverformung und/oder Ultraschallfrequenz bzw. Resonanzfrequenz und/oder Werkzeuggeschwindigkeit in dessen Schwingungsrichtung, wobei die Erfindung vorschlägt, dass die Bondvorrichtung zur Durchführung des Verfahrens gemäß einem oder mehreren der Ansprüche 32 bis 41 gemäß der am internationalen Anmeldetag eingereichten Fassung geeignet bzw. daran angepasst ausgebildet ist. Bezüglich dieser Ansprüche 32 bis 41 wird hier auch Bezug auf die vorangehende Beschreibung genommen. Merkmale zur bevorzugten Weiterbildung einer solchen Bondvorrichtung sind insbesondere auch in den Ansprüchen 43 bis 45 gemäß der am internationalen Anmeldetag eingereichten Fassung angegeben. Wie darin angegeben, kann die Bondvorrichtung eine Recheneinheit, insbesondere einen Computer mit Software aufweisen, welche an die automatisierte Ausführung von Verfahrensschritten gemäß einem oder mehreren der dem Anspruch 43 gemäß der am internationalen Anmeldetag eingereichten Fassung vorangehenden Verfahrensansprüche gemäß der am internationalen Anmeldetag eingereichten Fassung angepasst sind. Wie auch darin angegeben, kann die Bondvorrichtung einzelne oder mehrere Komponenten einer Bondvorrichtung gemäß einem oder mehreren der dem Anspruch 44 vorangehenden Ansprüche gemäß der am internationalen Anmeldetag eingereichten Fassung aufweisen. Wie auch darin angegeben, kann vorgesehen sein, dass die Bondvorrichtung, einen Speicher zur Speicherung von in Lernphasen erzeugten Soll-Verläufen aufweist und dass dieser Speicher mit der Bewertungseinheit zur Übertragung der Soll-Verläufe verbunden ist und insbesondere mit der Berechnungseinheit zum Empfang von Qualitätsindices (Q und/oder Qi) aus der Berechnungseinheit verbunden ist. Zu möglichen Wirkungen und Vorteilen wird ferner Bezug auf die gesamte Beschreibung und die Figuren genommen.

Mit Bezug auf die vorangehenden Ausführungen befasst sich die Erfindung mit der Bereitstellung eines selbstlernenden Systems, wobei die Vorrichtung bzw. das Verfahren zur Erzeugung einer von Produkt und Umgebung abhängigen Statistik als Grundlage der Qualitätsberechnung geeignet ist. In die Qualitätsberechnung können dabei theoretisch beliebig viele Eingangsgrößen einbezogen werden, die als Messgrößen bereitgestellt und/oder als abgeleitete Größen der Messgrößen in Realzeit berechnet werden können, z. B. durch Transformation der Messgrößen, Wavelet-Transformation, Schätzung der Streuung usw.. Es besteht die Möglichkeit der Erzeugung prozessintegrierter Qualitätsüberwachungsmodule unter Verwendung der beschriebenen Eingangsgrößen (Ist-Verläufe bzw. Ist-Vektoren) mit Referenzdaten (Soll-Verläufe bzw. Soll-Vektoren), die für die unterschiedlichen Prozesse in den entsprechenden Lernphasen gelernt bzw. automatisch erzeugt worden sind. Derartige Qualitätsüberwachungsmodule können an einer erfindungsgemäßen Bondvorrichtung (wie auch bei den anderen Aspekten der Erfindung) als Hardwaremodule und/oder als Softwaremodule ausgeführt sein, wobei derartige Module im Rahmen der verschiedenen Aspekte der Erfindung auch Gegenstand von selbstständigen Patentansprüchen sein können. Es besteht die Möglichkeit, eine konstante Anzahl von Eingangsvektoren zu berücksichtigen. Auch besteht die Möglichkeit der Generierung von Merkmalsvektoren durch Korrelation von unterschiedlichen Messgrößen identischer oder unterschiedlicher Zeitintervalle bzw. durch Korrelation von identischen Messgrößen aus unterschiedlichen Zeitintervallen. Es besteht auch die Möglichkeit, eine variable Anzahl von Eingangsvektoren durch Rückkopplung aus einer Überwachungseinheit zu berücksichtigen. Die Erfindung spiegelt schließlich auch die Möglichkeit der Erzeugung prozessintegrierter Qualitätsüberwachungsmodule unter Verwendung einer von durch eine Überwachungseinheit erweiterten Menge von Eingangsdaten sowie einer adaptiven Qualitätsberechnung. Es besteht die Möglichkeit der Transformation eines Fehlervektors auf eine skalare Qualitätsgröße.

Einer dritten Weiterbildung liegt die Aufgabe zugrunde, das Verfahren vorteilhaft weiterzubilden, so dass insbesondere eine verbesserte Rückmeldung über Betriebszustände ermöglicht wird.

Die Aufgabe wird zunächst und im wesentlichen durch die ggf. zusätzlichen Merkmale gelöst, dass während der Zeitdauer von Bondvorgängen mittels Sensoren Messsignale von mehreren Parametern, wie vorzugsweise Stromstärke und/oder Spannung am Ultraschallgenerator bzw. Transducer und/oder Drahtverformung und/oder Ultraschallfrequenz bzw. Resonanzfrequenz und/oder Werkzeuggeschwindigkeit, aufgenommen und jeweils als zeitliche Ist-Verläufe bereitgestellt, vorzugsweise in einem Speicher abgespeichert, werden, wobei die Möglichkeit besteht, dass aus Messsignalen von einem oder mehreren Parametern des Bondprozesses ein oder mehrere Ist-Verläufe von aus dem/den Parametern abgeleiteten Größen gebildet werden, dass mehrere Ist-Verläufe jeweils einer Vergleichs-Rechenoperation mit einem dem jeweiligen Ist-Verlauf bezüglich des Parameters bzw. der abgeleiteten Größe zugeordneten, in einem Speicher abgespeicherten Soll-Verlauf unterzogen werden, wobei zu den Ist-Verläufen jeweils ein Abweichungs-Verlauf, vorzugsweise durch Vergleich von einander zeitlich zugeordneten Einzelwerten, ermittelt wird, dass mittels geeigneter Rechenmittel aus Abweichungs-Verläufen jeweils ein Einzel- Qualitätsindex (skalare Größe) berechnet wird und dass eine Mehrzahl von Einzel-Qualitätsindices zumindest einer Bondverbindung als Bond-Indexgruppe mit mehreren verschiedenen, in einem Speicher, vorzugsweise in einem Expertensystem, abgelegten Speicher-Indexgruppen, welche sich untereinander durch die Werte der bestimmten Parameter bzw. abgeleiteten Größen zugeordneten Einzel-Qualitätsindices unterscheiden, unter Anwendung von zumindest einem vorgegebenen Ähnlichkeitskriterium verglichen und einer Speicher-Indexgruppe bei Erfüllung zumindest eines Ähnlichkeitskriteriums zugeordnet werden.

Die Ermittlung der genannten Einzel-Qualitätsindices wird dabei im Rahmen der Erfindung auch als Merkmals-Extraktion bezeichnet. In einem einfachen Anwendungsbeispiel kann ein Einzel-Qualitätsindex aus den Werten bzw. Skalaren des zugeordneten Abweichungs-Vektors durch Bildung des mathematischen Betrags ermittelt werden. Bevorzugt ist, dass bei Erfüllung eines Ähnlichkeitskriteriums für eine Speicher-Indexgruppe automatisch ein vorzugsweise elektrisches Klassifikationssignal erzeugt wird, das die Ausgabe von Informationen bewirkt und/oder zur Steuerung oder Regelung einer Bondvorrichtung verwendet wird. Zweckmäßig ist auch, dass verschiedenen Speicher-Indexgruppen in einem Speicher jeweils unterschiedliche Daten über den Betriebszustand einer Bondvorrichtung, vorzugsweise über unterschiedliche Fehlerzustände, zugeordnet sind und dass das erzeugte Klassifikationssignal bzw. Fehlerklassifikationssignal die Ausgabe von Information über diesen Betriebs- bzw. Fehlerzustand bewirkt. Gemäß einem weiteren Aspekt der Erfindung, der auch selbstständig Bedeutung besitzen kann, besteht die Möglichkeit, dass die bei der Merkmalsextraktion gebildeten Einzel-Qualitätsindices (welche bereits keinen Zeitbezug mehr besitzen) und/oder der Qualitätsindex und/oder Klassifikationssignale von während des Bondbetriebs hergestellten Bondverbindungen mittels einer Rechenoperationen ausführenden Überwachungseinrichtung unter Berücksichtigung bekannter Zusammenhänge bzw. Statistiken auf Ausreißer-Bonds analysiert werden. Zur Weiterbildung des Verfahrens kann die Gruppe der einem Ausreißer-Bond zugehörigen Einzel-Qualitätsindices in einem Speicher als eine neue Speicher-Indexgruppe abgespeichert und mit Daten über den Betriebs- bzw. Fehlerzustand verknüpft werden. Es besteht die Möglichkeit, dass von dem Ausreißer-Bond Messsignale, vorzugsweise dessen Ist-Verläufe, mittels Rechenmitteln statistisch zu abgeleiteten Größen umgewandelt und die daraus gebildeten Ist-Verläufe auf signifikante Merkmale, Verläufe usw. untersucht werden. Gemäß einem weiteren Aspekt der Erfindung, der ebenfalls selbstständig von Bedeutung sein kann, besteht auch die Möglichkeit, dass abgeleitete Größen, zu denen signifikante Merkmale festgestellt wurden, bei nachfolgenden Bondprozessen bei der Berechnung des Qualitätsindex verwendet werden. Auf diese Weise wird die Anzahl der Eingangsvektoren für die Merkmalsextraktion und die zukünftige Anzahl der in einer Indexgruppe enthaltenen Werte um 1 vergrößert. Durch ein solches Überwachungssystem wird vorteilhaft eine ständige Erweiterung bzw. Überprüfung der Qualitätsüberwachung sichergestellt und eine bestmögliche Modellbildung erreicht. Gemäß einem weiteren Aspekt der Erfindung, der ebenfalls selbstständig Bedeutung besitzen kann, besteht die Möglichkeit, dass bei vorbestimmten Abweichungen zwischen Bond-Indexgruppen und Speicher-Indexgruppen automatisch insbesondere elektrische Signale erzeugt werden, die vorzugsweise in Echtzeit zur Steuerung oder Regelung des aktuellen und/oder nachfolgender Bondvorgänge verwendet werden. Insofern handelt es sich um eine Gegenkopplung in Abhängigkeit von bekannten Speicher-Indexgruppen bzw. Fehlerklassen. Bevorzugt ist auch, dass das Verfahren gemäß einzelnen oder mehreren der zuvor beschriebenen Merkmale automatisiert nach Einstellungs- und/ oder Wartungsarbeiten an einer Bondverbindung durchgeführt wird. Als zweckmäßig wird bevorzugt, dass das Verfahren gemäß einem oder mehreren der zuvor beschriebenen Merkmale automatisiert, vorzugsweise rechnergestützt unter Verwendung von Software, durchgeführt wird.

Die Erfindung schließt auch betreffend ihrer dritten Weiterbildung weiterhin auch die ggf. zusätzlichen Merkmale einer Bondvorrichtung, vorzugsweise einer Ultraschall-Drahtbondvorrichtung, zur Herstellung und zur Qualitätskontrolle von Ultraschall-Bondverbindungen mit ein, welche gemäß Anspruch 57 gemäß der am internationalen Anmeldetag eingereichten Fassung zur Durchführung des erfindungsgemäßen Verfahrens mit einem oder mehreren der vorangehend beschriebenen Merkmale geeignet bzw. an dessen Ausführung angepasst ist. Bevorzugte mögliche Weiterbildungen sind auch in den Ansprüchen 58 bis 62 gemäß der am internationalen Anmeldetag eingereichten Fassung angegeben, wobei zu möglichen Wirkungen und Vorteilen in Bezug auf die gesamte Beschreibung und die Figuren genommen wird. Wie in den Ansprüchen 57 bis 62 gemäß der am internationalen Anmeldetag eingereichten Fassung angegeben, weist die Bondvorrichtung einen Ultraschallgenerator, einen Transducer, ein Bondwerkzeug sowie einen oder mehrere Sensoren zur Erfassung von Messsignalen von verschiedenen während des Bondens variablen Parametern auf sowie Mittel zur Durchführung des erfindungsgemäßen Verfahrens. Es kann insofern eine Bewertungseinheit vorgesehen sein, welche dazu geeignet beziehungsweise angepasst ist, Einzel-Qualitätsindices Qi zu Bond-Indexgruppen zusammenzufassen. Ebenso wird ein Speicher vorgesehen zum Abspeichern von Speicher-Indexgruppen sowie mit diesen separat verknüpften Daten. Ebenfalls umfasst ist ein Klassifikationsmodul, welches ein Vergleichsmodul aufweist, das für eine vergleichende Zuordnung von Bond-Indexgruppen zu Speicher-Indexgruppen unter Verwendung von vorgegebenen Ähnlichkeitskriterien und für eine Ausgabe von den mit solchen Speicher-Indexgruppen in einem Speicher verknüpften Daten beziehungsweise Informationen geeignet ist. Es kann eine Überwachungseinheit vorgesehen sein, welche ein Vergleichsmodul aufweist, das unter Verwendung von Ähnlichkeitskriterien an einem Vergleich von Bond-Indexgruppen zur Detektion von Ausreißer-Bond-Indexgruppen angepasst ist, die keine oder nur bestimmte Ähnlichkeitskriterien erfüllen. Die Überwachungseinheit kann zur Rückkopplung der Ergebnisse in die Qualitätsberechnung mit der Bewertungseinheit oder der Berechnungseinrichtung verbunden sein. Zur rückwärtigen Beeinflussung des aktuellen Bondvorgangs beziehungsweise nachfolgender Bondvorgänge können die Bewertungseinheit beziehungsweise die Berechnungseinrichtung beziehungsweise das Klassifikationsmodul mit einer Steuerungseinrichtung oder einer Regelungseinrichtung der Bondvorrichtung verbunden sein, welche auf eine oder mehrere Stellgrößen, insbesondere auf die Bondkraft beziehungsweise die Ultraschallleistung beziehungsweise die Bondzeit einwirkt.

Gemäß den vorangehenden Erläuterungen ermöglicht die Erfindung die Klassifizierung von bei Bondprozessen möglichen Fehlern, deren automatische Zuordnung zu Fehlerklassen und die automatisierte Benennung von Bondfehlern. Die Erfindung schließt insofern auch die Möglichkeit der Erzeugung von Korrekturgrößen in Realzeit in Abhängigkeit von Eingangstexturen in der Merkmalsextraktion und die Rückkopplung auf die Prozesssteuerung ein. Auch besteht die Möglichkeit der Erzeugung von Korrekturgröße in der Qualitätsberechnung in Form einer Trendanalyse und der Rückkopplung auf die Prozesssteuerung. Eine weitere Anwendungsmöglichkeit liegt in der Überwachung von Benutzereingriffen und der Überprüfung von Wartungsarbeiten. Die Erfindung ermöglicht auch die Transformation eines Fehlervektors auf eine skalare Qualitätsgröße.

Die Aspekte der vorliegenden Erfindung werden nachfolgend mit Bezug auf die beigefügten Figuren, in denen bevorzugte Ausführungsbeispiele des erfindungsgemäßen Verfahrens und erfindungsgemäßer Vorrichtungen dargestellt sind, näher beschrieben. Dabei zeigt:
- Fig. 1:: in Form eines Blockdiagramms eine zur rechnerischen Ermittlung von Einzel-Qualitätsindices und des Qualitätsindex geeignete Vorrichtung und Verfahrensweise gemäß der Erfindung,
- Fig. 2:: in Diagrammform eine Darstellung eines gelernten Statistikmodells eines Parameters oder einer abgeleiteten Größe,
- Fig. 3:: in Gestalt eines dreidimensionalen Diagramms eine Darstellung der Wahrscheinlichkeitsdichte einer Messgröße für die Abtastzeitpunkte,
- Fig. 4:: ausgehend von dem in Fig. 2 gezeigten Kurvenverlauf ein gewähltes Konfidenzintervall von 95 Prozent,
- Fig. 5:: als Blockdiagramm eine Vorrichtung und ein Verfahren gemäß der Erfindung zur Klassifizierung von Bondfehlern,
- Fig. 6:: ausgehend von Fig.5 eine Weiterbildung mit Feedback aus der Klassifizierungseinheit zur Prozesssteuerung oder -regelung,
- Fig. 7:: als Blockdiagramm schematisch eine Bondvorrichtung und ein Bondverfahren mit einem Ultraschallgenerator zur Einstellung von elektrischer Resonanz und
- Fig. 8:: als Blockdiagramm schematisch eine Bondvorrichtung und ein Bondverfahren mit einem Ultraschallgenerator zur Einstellung von mechanischer Resonanz gemäß der Erfindung.

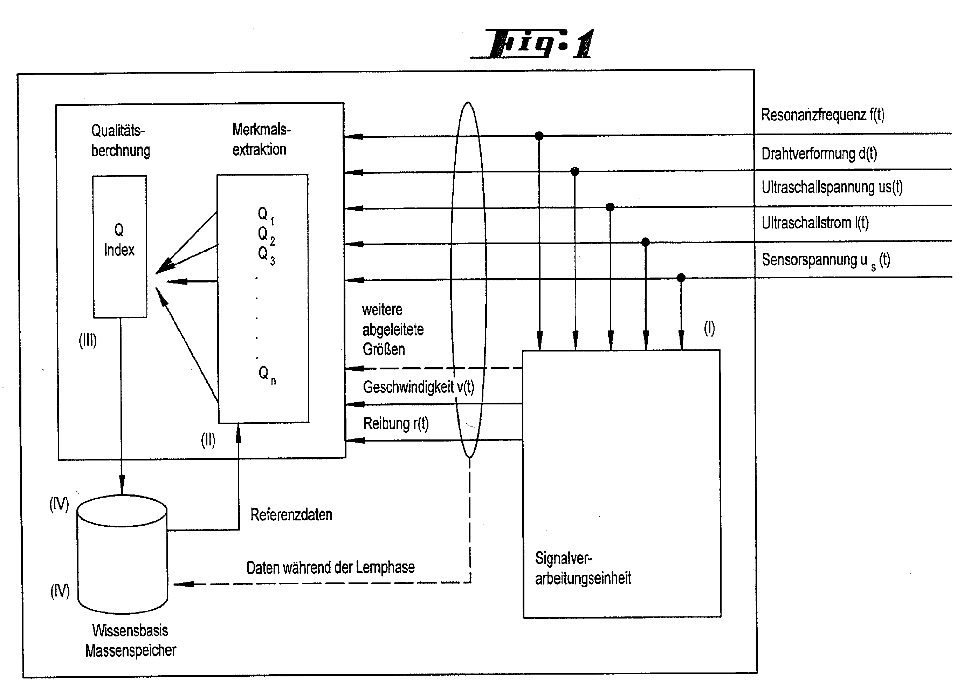

Figur 1 zeigt eine bevorzugte Anordnung von für die Berechnung der Qualitätsindices Q, Qi (d. h. Q₁ bis Qₙ) geeigneten Komponenten. Aus den Sensor-Rohdaten werden mit Hilfe einer speziellen Signalverarbeitungseinheit I die abgeleiteten Größen, unter anderem die Wedgegeschwindigkeit und die Reibung bestimmt. Zusammen mit den bereits genannten Messgrößen Strom, Admittanz, Verformung etc. und der in Realzeit bestimmten Resonanzfrequenz wird für jede dieser Größen in der Bewertungseinheit II im Rahmen der sogenannten Merkmalsextraktion (feature extraction) zunächst ein individueller Qualitätswert Qi berechnet. Diese individuellen Qualitätsindices Qi werden dann an die Berechnungseinheit III zur Qualitätsberechnung (quality calculation) für den Gesamtindex übergeben und dort wird dann der aus den gewichteten Einzelindices Qi der Qualitätsindex Q bzw. Q_{ges} der jeweiligen Bondverbindung berechnet. Dieser wird dann im Speicher IV abgelegt. Stellgrößen sind beispielsweise die Bondkraft, die Ultraschallleistung, die Bondzeit und/oder die Ultraschallfrequenz. Die Einzel-Qualitätsindices Q₁ ... Qₙ können als Vektor behandelt werden, aus welchem der Gesamt-Qualitätsindex Q berechnet werden kann. Jedes Element Qi (d. h. Q₁... Qₙ) stellt eine skalare Größe dar, die aus jeweils einem Abweichungs-Verlauf bzw. Abweichungs-Vektor einer Messgröße oder einer abgeleiteten Größe berechnet wurde, beispielsweise kann es sich bei der skalaren Größe um den, insbesondere bzgl. seiner einzelnen Elemente gewichteten, Vektorbetrag handeln.

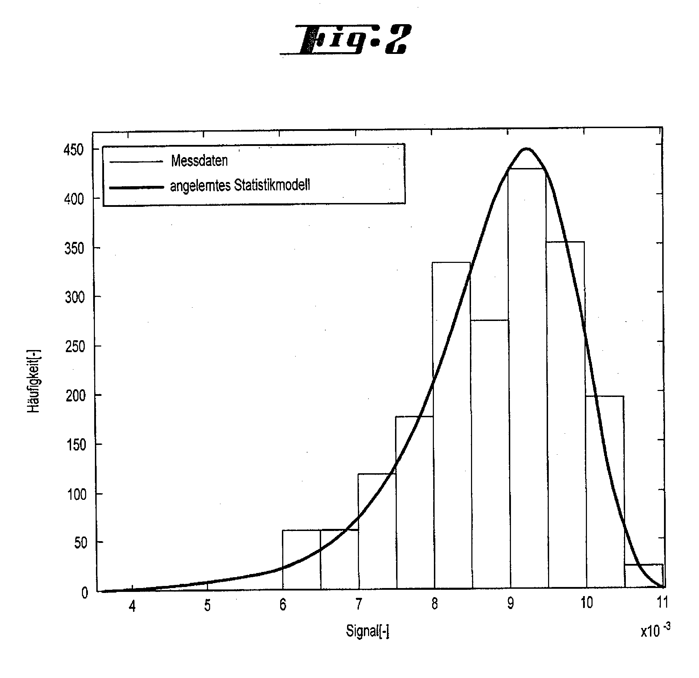

Aus den Messdaten, die gemäß einem Aspekt der Erfindung während der Lernphase aufgenommen werden, kann ein Modell für die Verbindungsbildung erzeugt werden, das für die Beurteilung der Verbindungsgüte geeignet ist. Die Figuren 2 bis 4 veranschaulichen eine bevorzugte die prinzipielle Vorgehensweise bei der Erzeugung einer für eine jeweilige Messgröße geltenden Statistik. In Figur 2 wird exemplarisch die Wahrscheinlichkeitsverteilung einer Messgröße zu einem bestimmten Abtastzeitpunkt dargestellt.

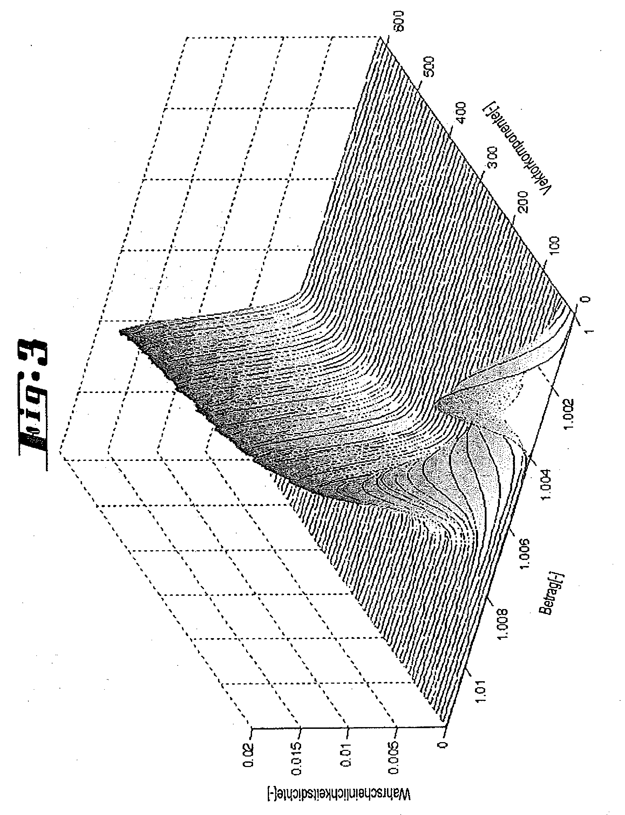

Zeichnet man alle abgetasteten Größen auf und betrachtet die relative Häufigkeit ihrer Amplituden, so erhält man auf diese Weise eine zweidimensionale Wahrscheinlichkeitsdichtefunktion über den Betrag der einzelnen Vektorkomponenten. Eine derartige Wahrscheinlichkeitsverteilung wird ebenfalls nur beispielhaft in Figur 3 dargestellt. Aus dieser Darstellung werden die Sollwertverläufe für die jeweiligen Messgrößen dadurch erzeugt, dass die Komponenten des Soll-Vektors bzw. des Soll-Verlaufes die jeweiligen Mittelwerte annehmen. Trägt man die jeweiligen Mittelwerte in einem Koordinatensystem über der Zeitachse zu den jeweiligen Abtastzeitpunkten ab und verbindet die Punkte durch eine Linie (Bezier, Spline o. ä.), dann erhält man die Kennlinie der betroffenen Messgröße für die gelernte Applikation, d. h. einen erfindungsgemäß erzeugten (d. h. "gelernten") Soll-Vektor bzw. Soll-Verlauf. Man kann diese Zahlenfolgen auch als einen Zeitvektor auffassen, dessen Komponenten genau einem Abtastzeitpunkt zugeordnet sind.

Es können allerdings auch Eingangsvektoren Verwendung finden, deren Komponenten bestimmten Werten anderer Messgrößen zugeordnet sind, so dass nicht jeder Vektor Komponenten enthält, die äquidistanten Abtastzeitpunkten zugeordnet werden können. Die Längen der Merkmalsvektoren können ebenfalls unterschiedlich sein, da ihre Wirkung auf das System für unterschiedlich große Bereiche der Bezugsgrößen von Bedeutung sein kann.

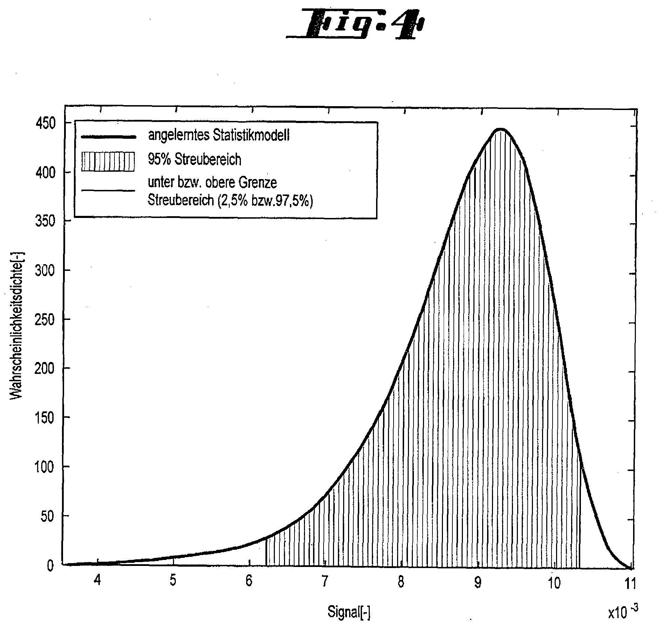

Die Statistikmodelle können in Abhängigkeit von der Eingangsgröße gewählt werden. Die Mindestmenge an Referenzbonds für eine repräsentative Statistik hängt vom gewählten Modell ab. Grundsätzlich sollte eine möglichst große und repräsentative Stichprobe angestrebt werden. Die Mindestgröße wird durch das System als Konstante fest vorgegeben. Die Größe des Streubereiches bzw. des Konfidenzintervalls (Figur 4) ist ein einstellbarer Parameter, zum Beispiel ein 99%-Streubereich; die Lage des Streubereiches bzw. des Konfidenzintervalls (Figur 4) um den jeweiligen Stichprobenmittelpunkt ergibt sich aus der gelernten Wahrscheinlichkeitsdichtefunktion und hängt somit vom gewählten Modell und von den Referenzdaten ab.

Die Qualitätsberechnung ist vorzugsweise in zwei Stufen unterteilt, nämlich in die Merkmalsextraktion bzw. Ermittlung der Einzel-Qualitätsindices Qi (Figur 1, Block II) und in die Qualitätsberechnung des Qualitätsindex Q (Figur 1, Block III). Zunächst wird zu jeder Größe (Parameter des Bondprozesses oder abgeleitete Größe) aus der zweidimensionalen Wahrscheinlichkeitsdichtefunktion der zu dem jeweiligen Abtastzeitpunkt gehörende Erwartungswert (statistischer Maximalwert) berechnet. Für alle Eingabegrößen (Komponenten der Eingangsvektoren) wird der Abstand zwischen Messwert und Stichprobenreferenzwert (Mittelwert, Median, Schwerpunkt etc.) bestimmt. Diese Merkmalsvektoren werden vorzugsweise komponentenweise auf die Ausdehnungen der Konfidenzintervalle normiert. Für die Auswertung können die aus der Statistik bekannten Methoden eingesetzt werden. Bei der Berechnung der Qualitätsindices werden für die jeweiligen Messgrößen unterschiedliche Statistiken, die sich an das zugrunde liegende Modell bestmöglich anpassen, verwendet. Die Gewichtung der einzelnen Werte und der Zeitraum, in dem diese Werte betrachtet werden, sind einstellbar. So kann zum Beispiel der Verformungsverlauf des Drahtes zu Beginn des Bondprozesses ohne Bedeutung sein bzw. kann unter Umständen in dieser Phase keine durch den Ultraschall hervorgerufene Verformung stattfinden. Sie kann also für die ersten Millisekunden des Prozesses unbeobachtet bleiben. Andere physikalische Effekte können insbesondere am Anfang des Schweißprozesses von großer Bedeutung sein, so beispielsweise der zeitliche Verlauf der Reibung zwischen den Verbindungspartnern. Schließlich werden die aus den Qi 's bestehenden Vektoren noch weiteren Transformationen unterzogen, um abgeleitete, von Störeinflüssen bereinigte Größen zu erhalten. Auf diese Weise werden weiteren Merkmalsvektoren hergestellt.

In einem nächsten Schritt werden die n Merkmalsvektoren am Eingang der Merkmalsextraktion auf n Skalare am Ausgang abgebildet. Diese können abermals als Vektor mit n Komponenten betrachtet werden und dienen der Qualitätsberechnung als Eingangsgröße. In der Qualitätsberechnung wird dieser Vektor nach einer der Bedeutung der Komponenten festgelegten Prozedur auf ein Skalar abgebildet. Dieses Skalar ist der gesuchte Qualitätswert Q. Ein Schwellwert der je nach Ausgestaltung einen Eingriff durch einen Bediener notwendig machen kann, ist ein einstellbarer Parameter.

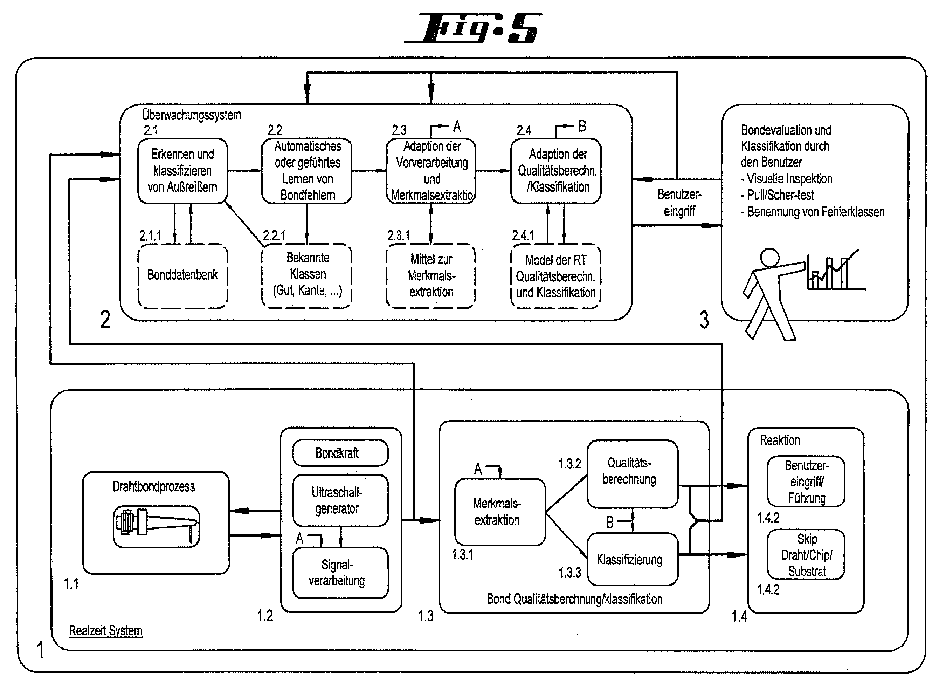

In Fortführung bzw. Weiterbildung der vorerwähnten Möglichkeiten können in einem weiteren Schritt Merkmalsvektoren (Q₁ ... Qₙ) bzw. Fehlervektoren hinsichtlich zu ihnen gehörender Fehler kategorisiert werden. Figur 5 zeigt den bevorzugten prinzipiellen Aufbau eines dazu geeigneten Systems. Die Berechnung der Qualitätswerte findet prinzipiell wie in Ausführungsform zwei beschrieben statt. Es wird ein weiteres Modul zur Verfügung gestellt, welches das Ergebnis einer Ergebnisklasse zuordnet und insoweit Fehlerursachen angeben kann (vgl. Figur 5, Block 1.3.3).

Die Rohdaten aus der Signalvorverarbeitung und dem Ultraschallgenerator werden nicht nur zur Merkmalsextraktion (feature extraction, Figur 5, 1.3.1) verwendet, sondern ebenfalls an eine nicht in Realzeit arbeitende Überwachungseinheit weitergeleitet. Ebenfalls erhält die Überwachungseinheit das Ergebnis der Qualitätsberechnung und des Fehlerklassifikators (Figur 5, 1.3.2 und 1.3.3). Die Merkmalsextraktion, die Qualitätsberechnung und die Fehlerklassifikation verfügen jeweils über einen weiteren Eingang, über den die Ergebnisse der Überwachungseinheit in die Berechnung der Qualitätswerte rückgekoppelt werden.

Das Überwachungssystem verarbeitet die oben genannten Werte unter Berücksichtigung der aktuell bekannten Statistiken. Es wird beispielsweise bei Substratwechsel oder nach einer vorher festgelegten Anzahl von durchgeführten Bondverbindungen aktiviert und untersucht die eingegangenen Daten zunächst auf Ausreißer (Figur 5, 2.1, (Ausreißer-Erkennung, Klassifikation)). Werden Ausreißer festgestellt, so werden diese an Block 2.2 (automatical or user guided learning of bond failure) übergeben und der Anwender hierüber in Kenntnis gesetzt. Es besteht die Möglichkeit, nach Untersuchung der aufgefallenen Bondverbindung dem System einen entsprechenden Fehlernamen mitzuteilen bzw. anhand des Untersuchungsergebnisses ein neues Merkmal als ein Qualitätsfeature freizugeben. Findet keine Benutzereingabe statt, so klassifiziert das Überwachungssystem den Ausreißer automatisch und weist einen automatisch generierten ID-Code ohne mnemonischen Bezug zu. Dieser neue Datenvektor wird an Block 2.3 der Überwachungseinheit übergeben und hier zu einem neuen Merkmalsvektor aufbereitet. Von hier aus wird auf das Realzeitsystem zurückgekoppelt (Figur 5, Block 1.3.1, Pfad A), die Anzahl der Eingangsvektoren für die Merkmalsextraktion wird um eins vergrößert (Block 1.3.1, Figur 5). In der hier beschriebenen Form entspricht dieser neue Eingangsvektor einer Kombination der von außen kommenden Rohdaten bzw. einer Transformation der Daten durch die Signalverarbeitungseinheit, siehe auch Figur 5, Block 1.2.

Die Dimension des Eingangsvektors für die Qualitätsberechnung/Fehlerklassifizierung wird damit ebenfalls um eins vergrößert. Der neue Merkmalsvektor wird des weiteren von Block 2.3 an Block 2.4 (Adaption der Qualitätsberechnung und Klassifikation) übergeben. In diesem Bereich wird anhand der neuen Daten das Modell auf Konsistenz überprüft, ggf. adaptiert und an die Qualitätsberechnung und den Fehlerklassifikator zurückgegeben (Figur 5, Block 1.3.2 und 1.3.3, Pfad B). Auf diese Weise wird durch das Überwachungssystem eine ständige Erweiterung bzw. Überprüfung der Qualitätsüberwachung sichergestellt und eine bestmögliche Modellbildung erreicht.

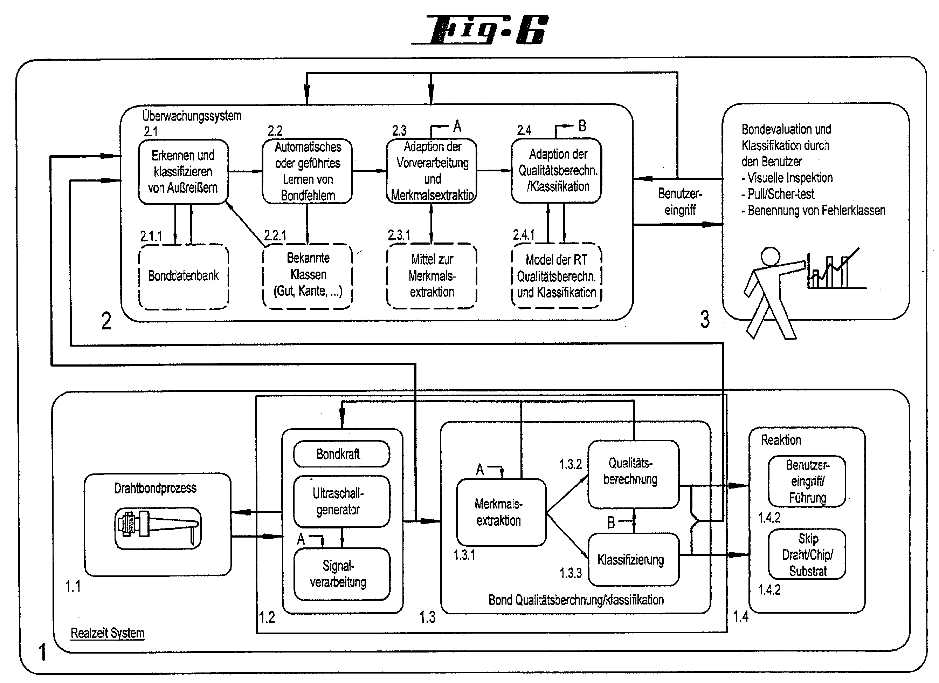

Gemäß einem weiteren Aspekt der Erfindung kann in Kenntnis der berechneten Qualität und des zugrunde liegenden Modells bereits bei der Berechnung der zu den einzelnen Messgrößen gehörenden Vektorkomponenten, die in aller Regel eine Funktion der Zeit sind, in Realzeit eine Abweichung vom Modell bemerkt und durch geeignete Parameteranpassung zur Prozesslaufzeit auf den Prozess eingewirkt werden (siehe auch Figur 6, Gegenkopplung von 1.3.1 und 1.3.2 auf 1.2). Ein gegengekoppeltes System wird zwar auch von EP 1 023 139 beschrieben, allerdings liegt dort lediglich ein fest vorgegebenes Modell in Form von Kennlinien zugrunde. Die Bestimmung von Fehlerklassen und die Gegenkopplung in Abhängigkeit dieser Fehlerklassen und die Gegenkopplung in Abhängigkeit dieser Fehlerklassen ist dort nicht offenbart. Insoweit stellt die vorliegende Erfindung eine völlig neue Lösung bereit, die auch eine fehlerbezogene Rückkopplung auf die den Schweißprozess beeinflussenden Größen erlaubt.

Gemäß einem weiteren Aspekt der Erfindung, welcher auch eigenständig von Bedeutung sein kann, können die zuvor beschriebenen Verfahrensschritte und Merkmale eine Bondvorrichtung auch zur Überprüfung von Benutzereingriffen verwendet werden. Aufgrund einer genauen Kenntnis eines Transducer-Wedge-Systems kann auch beispielsweise überprüft werden, ob beispielsweise der Transducer nach Wartungsarbeiten korrekt montiert ist, ob das Wedge ordnungsgemäß eingebaut wurde und mit der richtigen Vorspannung der Wedgeschraube fixiert wurde. Auch die Beschaffenheit der Klemmung und der Bondaufnahme kann anhand der gelernten Texturen bzw. Verläufe auf korrekte Funktion hin überprüft werden.

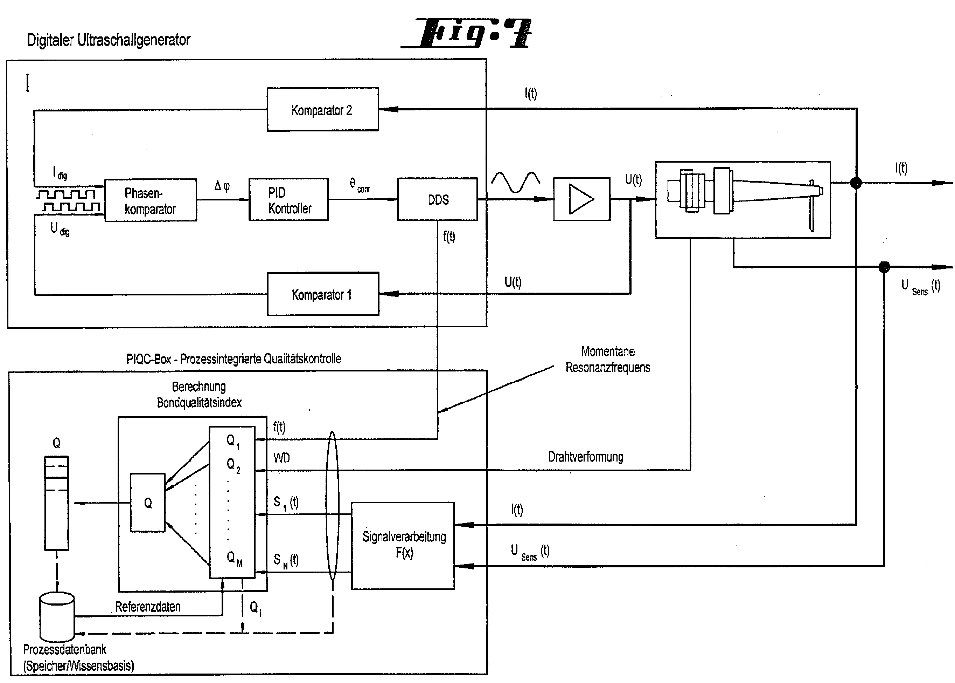

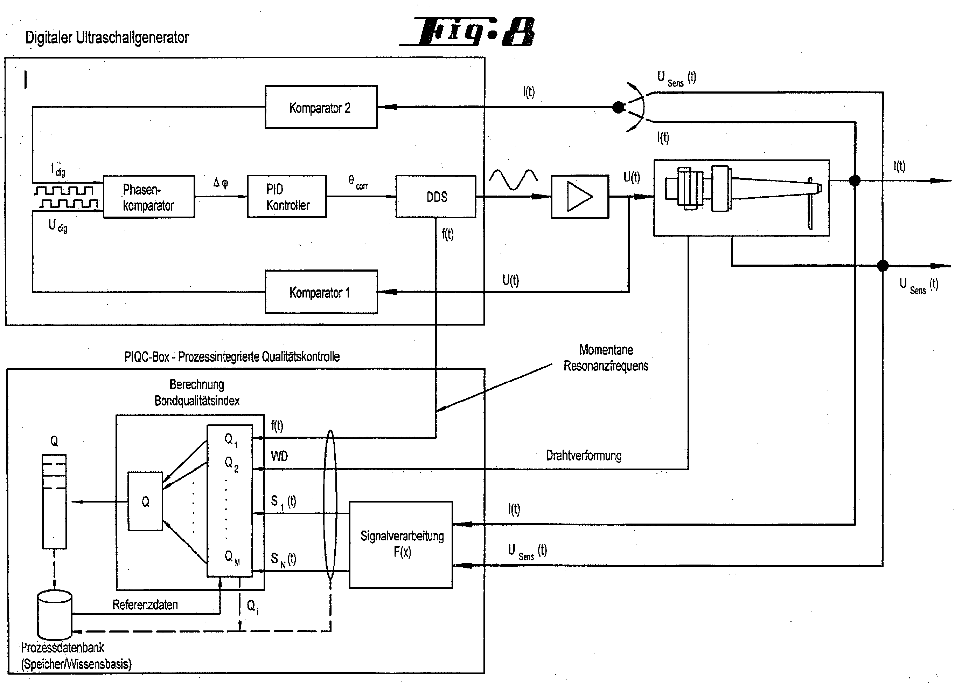

In Block I der Figuren 7 und 8 sind wesentliche Komponenten eines Ultraschallgenerators gemäß einer ersten Ausführungsform dargestellt. Die Komparatoren 1 und 2 formen die Sinussignale für Strom und Spannung jeweils in Rechtecksignale um, deren Nulldurchgang jeweils mit den Nulldurchgängen der Sinusschwingungen zusammenfallen. Mit dem Phasenkomparator wird dann die Phasendifferenz zwischen Strom und Spannung des Ultraschallsignals bestimmt. Der so bestimmte Phasen-Istwert wird dem nachfolgenden Phasenregler (PID-Controller) als Eingangsgröße zugeführt. Der Phasen-Sollwert für Resonanz ist Null. Die Ausgangsgröße des Reglers ist die Eingangsgröße des DDS (Direct Digital Synthesizer), die Größe θ_{corr} ist das Phaseninkrement, anhand dessen die Frequenz des Ausgangssignals des DDS eingestellt wird. Dieses Signal wird dann mittels eines Leistungsverstärkers verstärkt und dem Ultraschall-Transducer zugeführt. Der Regler verändert am Ausgang seine Größe θ_{corr} so, dass die daraus resultierende Frequenz des DDS an der Last (Transducer-Wedge-System) die Phasendifferenz Null zwischen der Ultraschallspannung und Ultraschallstrom ergibt. Eine solche Anordnung ist geeignet zur Einstellung von elektrischer Resonanz.

In Figur 8, welche eine gegenüber Figur 7 modifizierte und bevorzugte Ausführungsform zeigt, kann man wählen, ob der Strom oder ein alternatives Sensorsignal über den Komparator zum Phasenvergleich geführt wird. Das alternative Sensorsignal ist - von einem Phasenoffset abgesehen - ein Maß für die Wedgegeschwindigkeit und kann insoweit zur Einstellung der mechanischen Resonanz verwendet werden.

Alle offenbarten Merkmale sind erfindungswesentlich. Auch können beschriebene einzelne Aspekte der Erfindung, insbesondere auch deren einzelnen Merkmale, auch mit einzelnen oder mehreren der weiteren beschriebenen Aspekte der Erfindung kombiniert werden. kombiniert werden.

## Patentansprüche

1. Verfahren zur Qualitätskontrolle beim Ultraschall-Bonden, insbesondere beim Ultraschall-Drahtbonden, bei welchem eine Transducer-Bondwerkzeug-Einheit und ein Ultraschall-Generator verwendet werden und bei dem während des Bondens mittels eines oder mehrerer Sensoren Messsignale von einem oder mehreren, während des Bondens variablen Parametern zur Beurteilung der Bondqualität und/ oder zur Beeinflussung des Bondens erfasst werden, wobei während des Bondens zumindest ein den Zeit-Geschwindigkeits-Verlauf der Spitze des Ultraschallwerkzeuges in deren Schwingungsrichtung, insbesondere bezüglich seines Schwingungs-Phasenverlaufes, repräsentierendes Geschwindigkeitsverlauf-Messsignal mittels eines Piezosensors in Echtzeit erfasst wird, **dadurch gekennzeichnet, dass** mittels des Piezosensors eine Querdehnung senkrecht zu einer sich ausbreitenden anregenden Ultraschallwelle messtechnisch erfasst wird, dass ein den Zeit-Generatorspannungs-Verlauf repräsentierendes Spannungsverlauf-Messsignal und das Geschwindigkeitsverlauf-Messsignal einem Phasenregler zugeleitet werden, dass mittels des Phasenreglers die Schwingungsfrequenz des Ultraschallwerkzeuges so eingestellt bzw. verändert wird, dass die Phasendifferenz automatisch, insbesondere bis im Wesentlichen oder bis genau auf Null, verringert wird zur Erzielung mechanischer Resonanz der Transducer-Bondwerkzeug-Einheit, und dass der dem Ultraschalltransducer von dem Ultraschallgenerator zugeordnete Zeit-Generatorspannungs-Verlauf gemessen wird, dass die zu dem Geschwindigkeitsverlauf-Messsignal bestehende Phasendifferenz ermittelt wird und dass mittels des Ultraschallgenerators die Schwingungsfrequenz des Ultraschallwerkzeuges so eingestellt bzw. verändert wird, dass die genannte Phasendifferenz verringert, insbesondere bis im Wesentlichen oder bis genau auf Null verringert, wird.

2. Verfahren nach Anspruch 1, **dadurch gekennzeichnet, dass** der bei einem aktuellen Prozesszustand des Bondvorganges ermittelte Reibungswert zur Steuerung und/ oder Regelung des Weiteren aktuellen Bondvorganges und/ oder nachfolgender Bondvorgänge, insbesondere im Wege einer Beeinflussung von Stellgrößen wie beispielsweise Bondkraft, Ultraschallleistung, Bondzeit und/oder Ultraschallfrequenz, verwendet wird.

3. Verfahren nach Anspruch 1 oder 2, **dadurch gekennzeichnet, dass** aus dem Reibungswert-Zeitverlauf als einem Ist-Verlauf und aus entweder einem vorgegebenen Soll-Reibungswert-Zeitverlauf als Soll-Verlauf oder einem zuvor in einer Lernphase ermittelten und abgespeicherten Soll-Reibungswert-Zeitverlauf als Soll-Verlauf mittels eines Rechners ein Abweichungs-Verlauf und daraus insbesondere ein die Qualität eines Bondvorganges bzw. einer Bondverbindung kennzeichnender Qualitätswert, wie Einzel-Qualitäts-index oder Qualitätsindex, ermittelt wird.

4. Verfahren nach einem oder mehreren der vorangehenden Ansprüche, **dadurch gekennzeichnet, dass** der Qualitätswert zur Steuerung und/ oder Regelung von nachfolgenden Bondvorgängen insbesondere im Wege einer Beeinflussung von Stellgrößen wie beispielsweise Bondkraft, Ultraschallleistung, Bondzeit und/ oder Ultraschallfrequenz, verwendet wird und/oder bei Erreichen kritischer Werte zur Ausgabe von Warnsignalen verwendet wird.

5. Bondvorrichtung, insbesondere Drahtbonder, zur Herstellung und zur Qualitätskontrolle von Ultraschallbondverbindungen, aufweisend eine Transducer-Bondwerkzeug-Einheit und einen Ultraschall-Generator sowie zumindest einen Sensor zur Gewinnung von Messsignalen von zumindest einem während des Bondens variablen Parameter, wobei die Bondvorrichtung zumindest einen Piezosensor aufweist, der zur Erzeugung eines den Zeit-Geschwindigkeits-Verlauf der Spitze des Ultraschallwerkzeuges in deren Schwingungsrichtung, bezüglich des Schwingungs-Phasenverlaufes, repräsentierenden Geschwindigkeitsverlauf-Messsignals geeignet ist, **dadurch gekennzeichnet, dass** der Piezosensor in/ an einer Lagerung des Ultraschalltransducers angeordnet ist und mittels dem Piezosensor insbesondere eine Querdehnung senkrecht zu einer sich ausbreitenden anregenden Ultraschallwelle messtechnisch erfassbar ist, und dass die Bondvorrichtung einen Spannungssensor zur Erfassung des dem Ultraschalltransducer zugeordneten Zeit-Generatorspannungs-Verlaufs und einen Phasenregler aufweist, der mit dem Sensor bzw. Piezosensor in Verbindung steht und der die Phasendifferenz zwischen dem Zeit-Generatorspannungs-Verlauf und dem Sensor-Signalverlauf bzw. dem Geschwindigkeitsverlauf-Messsignal mittels eines Phasenkomparators erfasst und diese mittels Veränderung der Werkzeug-Schwingungsfrequenz an dem Ultraschallgenerator zur Erzielung von mechanischer Resonanz der Transducer-Bondwerkzeug-Einheit verringert, insbesondere bis zum vollständigen Verschwinden der Phasendifferenz.

6. Bondvorrichtung nach Anspruch 5, **dadurch gekennzeichnet, dass** die Bondvorrichtung Speichermittel aufweist, in denen zumindest ein vorgegebener Soll-Reibungswert-Zeitverlauf oder zumindest ein zuvor in einer Lernphase ermittelter Soll-Reibungswert-Zeitverlauf ab gespeichert ist, sowie Rechenmittel, die an die Berechnung eines die Qualität eines Bondvorganges bzw. einer Bondverbindung kennzeichnenden Qualitätswertes unter Verwendung des Soll-Reibungs-Verlaufs und des bei einem Bondvorgang ermittelten Reibungswert-Zeitverlaufs als Ist-Verlauf, insbesondere mittels Berechnung eines Abweichungs-Verlaufs aus Differenzen zwischen einander zeitlich entsprechenden Werten beider Verläufe, angepasst sind.

7. Bondvorrichtung nach Anspruch 5 oder 6, **dadurch gekennzeichnet, dass** die Bondvorrichtung in deren Charakteristik durch den Abweichungs-Verlauf und/ oder den Qualitätswert beeinflussbare Steuer- und/oder Regelmittel zur Steuerung und/oder Regelung des aktuellen und/oder von nachfolgenden Bondvorgängen aufweist, welche insbesondere auf Stellgrößen des Bondprozesses, wie insbesondere Bondkraft, Ultraschallleistung, Bondzeit und Ultraschallfrequenz, Einfluss nehmen.

## Claims

1. Method for quality control during ultrasonic bonding, in particular during ultrasonic wire bonding, in which a transducer-bonding tool unit and an ultrasonic generator are used, and in which, during bonding, one or a plurality of sensors detect measurement signals from one or a plurality of parameters, which can vary during bonding, in order to assess the bonding quality and/or to influence bonding, wherein, during bonding, at least one speed profile measurement signal which is representative of the time-speed profile of the tip of the ultrasonic tool in the oscillation direction thereof, in particular with respect to its oscillation phase profile, is detected in real time by means of a piezoelectric sensor, **characterised in that** by means of the piezoelectric sensor a transverse expansion perpendicular to a propagating exciting ultrasonic wave is detected by measurement technology, that a voltage profile measurement signal, which is representative of the time-generator voltage profile, and the speed profile measurement signal are supplied to a phase regulator, that by means of the phase regulator the oscillation frequency of the ultrasonic tool is set and/or changed in such a way that the phase difference is reduced automatically, in particular to substantially or to precisely zero, in order to achieve mechanical resonance of the transducer-bonding tool unit, and that the time-generator voltage profile assigned to the ultrasonic transducer of the ultrasonic generator is measured, that the phase difference existing in respect of the speed profile measurement signal is determined and that by means of the ultrasonic generator the oscillation frequency of the ultrasonic tool is set and/or changed in such a way that said phase difference is reduced, in particular is reduced to substantially or to precisely zero.

2. Method as claimed in claim 1, **characterised in that** the coefficient of friction, which is determined in a current process state of the bonding process, is used for controlling and/or regulating the further current bonding process and/or subsequent bonding processes, in particular in the course of influencing manipulated variables such as e.g. bonding force, ultrasonic power, bonding time and/or ultrasonic frequency.

3. Method as claimed in claim 1 or 2, **characterised in that** a deviation profile, and therefrom in particular a quality value characterising the quality of a bonding process or of a bonded connection, such as individual quality index or quality index, is determined by means of a computer from the coefficient of friction-time profile as an actual profile and from either a preset desired coefficient of friction-time profile as a desired profile or a desired coefficient of friction-time profile, which is previously determined and stored in a learning phase, as a desired profile.

4. Method as claimed in any one or several of the preceding claims, **characterised in that** the quality value is used for controlling and/or regulating subsequent bonding processes, in particular in the course of influencing manipulated variables such as e.g. bonding force, ultrasonic power, bonding time and/or ultrasonic frequency, and/or is used upon achieving critical values for outputting warning signals.

5. Bonding apparatus, in particular wire bonder, for producing and for quality control of ultrasonic bonded connections, comprising a transducer-bonding tool unit and an ultrasonic generator as well as at least one sensor for obtaining measurement signals from at least one parameter which can vary during bonding, wherein the bonding apparatus has at least one piezoelectric sensor which is suitable for generation of a speed profile measurement signal which is representative of the time-speed profile of the tip of the ultrasonic tool in the oscillation direction thereof, with respect to the oscillation phase profile, **characterised in that** the piezoelectric sensor is disposed in/on a bearing of the ultrasonic transducer and, by means of the piezoelectric sensor, in particular a transverse expansion perpendicular to a propagating exciting ultrasonic wave can be detected by measurement technology, and that the bonding apparatus has a voltage sensor for detection of the time-generator voltage profile, which is assigned to the ultrasonic transducer, and a phase regulator which is connected to the sensor or piezoelectric sensor and which detects the phase difference between the time-generator voltage profile and the sensor signal profile or the speed profile measurement signal by means of a phase comparator and reduces this phase difference by means of a change in the tool oscillation frequency at the ultrasonic generator in order to achieve mechanical resonance of the transducer-bonding tool unit, in particular until the phase difference has completely disappeared.

6. Bonding apparatus as claimed in claim 5, **characterised in that** the bonding apparatus has storage means in which at least one preset desired coefficient of friction-time profile or at least one desired coefficient of friction-time profile previously determined in a learning phase is stored, as well as computing means which are adapted for the calculation of a quality value, which characterises the quality of a bonding process or of a bonded connection, using the desired friction profile and the coefficient of friction-time profile, which is determined during a bonding process, as an actual profile, in particular by means of calculation of a deviation profile from differences between values of both profiles which correspond to one another in terms of time.

7. Bonding apparatus as claimed in claim 5 or 6, **characterised in that** the bonding apparatus comprises control and/or regulating means, the characteristics of which can be influenced by the deviation profile and/or the quality value, for controlling and/or regulating the current bonding process and/or subsequent bonding processes, which, in particular, influence manipulated variables of the bonding process such as, in particular, bonding force, ultrasonic power, bonding time and ultrasonic frequency.

## Revendications

1. Procédé de contrôle de qualité lors du soudage par ultrasons, en particulier lors du soudage de fils par ultrasons, dans lequel on utilise une unité transducteur-outil de soudage et un générateur d'ultrasons et dans lequel, pendant le soudage, au moyen d'un ou plusieurs capteurs des signaux de mesure d'un ou plusieurs paramètres variables pendant le soudage sont détectés pour évaluer la qualité du soudage et/ou agir sur le soudage, dans lequel, pendant le soudage, au moins un signal de mesure de la courbe de vitesse représentant la courbe temps-vitesse de la pointe de l'outil à ultrasons est détecté en temps réel au moyen d'un capteur piézoélectrique dans sa direction de vibration en particulier par rapport à sa courbe de phase de vibration, **caractérisé en ce que**, au moyen du capteur piézoélectrique, un allongement transversal vertical par rapport à une onde à ultrasons excitant et se propageant est détecté en termes de techniques de mesure, qu'un signal de mesure de courbe de tension représentant la courbe temps-tension de générateur et le signal de mesure de courbe de vitesse sont transmis à un régulateur de phase, qu'au moyen du régulateur de phase la fréquence de vibration de l'outil à ultrasons est réglée ou modifiée de telle manière que la différence de phase est diminuée automatiquement, en particulier jusqu'à sensiblement ou exactement zéro, pour obtenir de la résonance mécanique de l'unité transducteur-outil de soudage, et que la courbe temps-tension de générateur associée au transducteur à ultrasons par le générateur d'ultrasons est mesurée, que la différence de phase existant par rapport au signal de mesure de courbe de vitesse est déterminée et que la fréquence de vibration de l'outil à ultrasons est réglée ou modifiée au moyen du générateur d'ultrasons de telle manière que ladite différence de phase est diminuée, en particulier jusqu'à sensiblement ou exactement zéro.

2. Procédé selon la revendication 1, **caractérisé en ce que** le coefficient de frottement déterminé dans un état du processus actuel de l'opération de soudage est utilisé pour commander et/ou réguler l'opération de soudage actuelle ultérieure et/ou des opérations ultérieures, en particulier en agissant sur des grandeurs de réglage comme par exemple force de soudage, puissance des ultrasons, temps de soudage et/ou fréquence des ultrasons.

3. Procédé selon la revendication 1 ou 2, **caractérisé en ce que**, à partir de la courbe temporelle de coefficient de frottement en tant que courbe effective et à partir soit d'une courbe temporelle de coefficient de frottement de consigne prédéterminée en tant que courbe de consigne, soit d'une courbe temporelle de coefficient de frottement de consigne déterminée au préalable dans une phase d'apprentissage et stockée en tant que courbe de consigne, une courbe de déviation et à partir de cette dernière en particulier une valeur de qualité, comme un indice de qualité individuel ou un indice de qualité, caractérisant la qualité d'une opération de soudage ou d'une liaison de soudage est déterminée au moyen d'un calculateur.

4. Procédé selon une ou plusieurs des revendications précédentes, **caractérisé en ce que** la valeur de qualité est utilisée pour commander et/ou réguler des opérations de soudage ultérieures en particulier en agissant sur des grandeurs de réglage comme par exemple force de soudage, puissance des ultrasons, temps de soudage et/ou fréquence des ultrasons et/ou est utilisée lorsque des valeurs critiques sont atteintes pour l'émission de signaux d'avertissement.

5. Dispositif de soudage, en particulier microsoudeuse de fils, destiné à la production et au contrôle de qualité de liaisons par soudage par ultrasons, présentant une unité transducteur-outil de soudage et un générateur d'ultrasons ainsi qu'au moins un capteur pour obtenir des signaux de mesure d'au moins un paramètre variable pendant le soudage, le dispositif de soudage présentant au moins un capteur piézoélectrique, qui est adapté pour générer un signal de mesure de la courbe de vitesse représentant la courbe temps-vitesse de la pointe de l'outil à ultrasons dans sa direction de vibration, par rapport à sa courbe de phase de vibration, **caractérisé en ce que** le capteur piézoélectrique est disposé dans/au niveau d'un support du transducteur à ultrasons et qu'au moyen du capteur piézoélectrique en particulier un allongement transversal vertical par rapport à une onde à ultrasons excitant et se propageant peut être détecté en termes de techniques de mesure, et
que le dispositif de soudage présente un capteur de tension pour la détection de la courbe temps-tension de générateur associée au transducteur à ultrasons et un régulateur de phase, qui est relié au capteur ou au capteur piézoélectrique et qui détecte la différence de phase entre la courbe temps-tension de générateur et la courbe de signal de capteur ou le signal de mesure de courbe de vitesse au moyen d'un comparateur de phase et diminue cette différence de phase au moyen d'une modification de la fréquence d'oscillation de l'outil au niveau du générateur d'ultrasons pour obtenir une résonance mécanique de l'unité transducteur-outil de soudage, en particulier jusqu'à la disparition complète de la différence de phase.

6. Dispositif de soudage selon la revendication 5, **caractérisé en ce que** le dispositif de soudage présente des moyens de stockage dans lesquels au moins une courbe temporelle de coefficient de frottement de consigne prédéfinie ou au moins une courbe temporelle de coefficient de frottement de consigne déterminée au préalable durant une phase d'apprentissage est stockée, ainsi que des moyens de calcul, qui sont adaptés au calcul d'une valeur de qualité caractérisant la qualité d'une opération de soudage ou d'une liaison de soudage en utilisant la courbe de frottement de consigne et la courbe temporelle de coefficient de frottement déterminée lors d'une opération de soudage en tant que courbe effective, en particulier au moyen du calcul d'une courbe de déviation à partir de différences entre les valeurs correspondantes entre elles dans le temps des deux courbes.

7. Dispositif de soudage selon la revendication 5 ou 6, **caractérisé en ce que** le dispositif de soudage présente dans sa caractéristique des moyens de commande et/ou de régulation influençables par la courbe de déviation et/ou la valeur de qualité pour commander et/ou réguler les opérations de soudage actuelle ou ultérieures, qui peuvent agir en particulier sur des valeurs de grandeur du processus de soudage, comme par exemple force de soudage, puissance des ultrasons, temps de soudage et/ou fréquence des ultrasons.
